(19) Europäisches Patentamt
European Patent Office
Office européen des brevets

(11) EP 1 923 742 A1

(12) EUROPEAN PATENT APPLICATION
published in accordance with Art. 153(4) EPC

(43) Date of publication:
21.05.2008 Bulletin 2008/21

(21) Application number: 06797267.9

(22) Date of filing: 01.09.2006

(51) Int Cl.:
*G03F 7/023* (2006.01) *G03F 7/022* (2006.01)
*G03F 7/40* (2006.01) *H01L 21/027* (2006.01)

(86) International application number:
PCT/JP2006/317325

(87) International publication number:
WO 2007/029614 (15.03.2007 Gazette 2007/11)

(84) Designated Contracting States:
AT BE BG CH CY CZ DE DK EE ES FI FR GB GR HU IE IS IT LI LT LU LV MC NL PL PT RO SE SI SK TR

(30) Priority: 05.09.2005 JP 2005256530
26.07.2006 JP 2006202764

(71) Applicants:
- Asahi Kasei EMD Corporation
Tokyo 160-0023 (JP)
- PI R & D Co. Ltd
Yokohama-shi,
Kanagawa 236-0002 (JP)

(72) Inventors:
- KANADA, Takayuki
Tokyo 1008440 (JP)
- HANAHATA, Hiroyuki
Tokyo 1008440 (JP)
- JIN, Xingzhou
Kanagawa 2360002 (JP)
- WAKI, Shuzo
Kanagawa 2360002 (JP)

(74) Representative: Strehl Schübel-Hopf & Partner
Maximilianstrasse 54
80538 München (DE)

# (54) POSITIVE PHOTOSENSITIVE RESIN COMPOSITION

(57) A photosensitive resin composition comprising 100 parts by mass of polycondensate (A) having a structure resulting from dehydration condensation between one or two or more tetracarboxylic acid dianhydride and one or two or more armatic diamines having mutually ortho-positioned amino and phenolic hydroxyl groups and 1 to 100 parts by mass of photosensitive diazonaphthoquinone compound (B), wherein the polycondensate (A) has a weight average molecular weight of 3000 to 70,000.

FIG.1

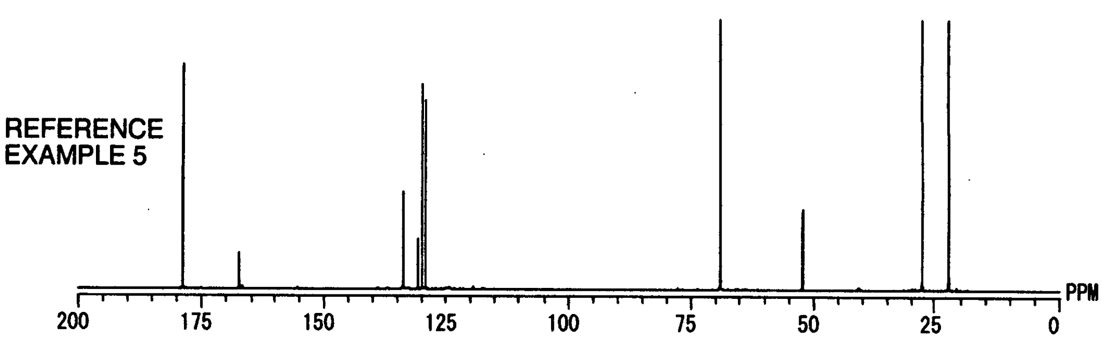




Printed by Jouve, 75001 PARIS (FR)

## Description

TECHNICAL FIELD

The present invention relates to a positive photosensitive resin composition which can be used for forming the relief pattern of a heat-resistant resin material used for the insulating material of electronic parts and display elements, as well as the passivation film, buffer coating and interlayer insulation film of semiconductor devices and the like.

BACKGROUND ART

It is widely known that polyimide resin, which combines excellent heat resistance, electrical properties and mechanical properties, is suitable for applications as the surface protection film or an interlayer insulation film of a semiconductor device. Polyimide resin used in such applications is usually provided in the form of a photosensitive polyimide precursor composition, which is coated on a substrate such as a silicon wafer. By successively subjecting to patterning-exposure with active rays, developing and thermal imidization treatment, a heat-resistant resin coating having a fine relief pattern can be easily formed on the substrate.

However, when using the above-described photosensitive polyimide precursor composition, during the developing step, a large amount of organic solvent has to be used for the developing solution. From the perspectives of cost and safety as well as the recent increasing interest in environmental problems, measures for providing a non-organic solvent are being demanded. In consideration of this, similar to photoresists, recently various heat-resistant photosensitive resin materials capable of being developed by a dilute aqueous alkaline solution have been proposed. Among these, photosensitive resin compositions composed of a polybenzoxazole (hereinafter referred to as "PBO") precursor, which is a polyhydroxyamide that is soluble in dilute aqueous alkaline solution, and a photoactive component (PAC), such as a photosensitive diazonaphthoquinone compound (hereinafter referred to as "NQD") have recently been drawing attention. Photosensitive PBO precursor compositions easily form a relief pattern and have good storage stability. Further, since the same thermosetting coating properties as those for a polyimide can be obtained, photosensitive PBO precursor compositions are drawing attention as a promising substitute material for photosensitive polyimide precursor compositions. In addition, there have also been many proposals as a heat-resistant photosensitive resin composition capable of being developed by a dilute aqueous alkaline solution, such as the combination of a polymer having a phenolic hydroxyl group introduced on its main chain and a PAC, the combination of a polymer having a phenolic hydroxyl group introduced on a side chain and a PAC, and the combination of a polyimide-PBO precursor polymer having polyimide precursor units and PBO precursor units alternate in the skeleton by using a trimellitic acid and a PAC.

Polymers used in the above-described heat-resistant photosensitive resin compositions are all polyimide or PBO precursors. To obtain a cured relief pattern which is thermally and mechanically excellent, after the relief pattern has been formed from exposing and developing, such precursors must be subjected to a heat treatment to carry out a cyclodehydration reaction for subsequent conversion to the heat-resistant resin polyimide or PBO. At this stage, the required temperature is generally high, exceeding 300˚C.

However, as for MRAMs or other semiconductor devices which have recently appeared, in some cases a heat treatment at such a high temperature cannot be conducted. If the above-described heat treatment is conducted at a low temperature, the cyclodehydration reaction to the polyimide or the PBO is insufficient, whereby the obtained cured relief pattern usually has reduced mechanical properties. Therefore, when the heat treatment is conducted at a low temperature, depending on the application cracks may appear in the coating or peeling can occur, giving rise to the problem that reliability cannot be obtained.

Therefore, there is a strong need for a heat-resistant photosensitive resin composition in which the conversion to a heat-resistant resin polyimide or to PBO sufficiently progresses by heat treatment at a low temperature of 300˚C or less, and in which the mechanical properties can be sufficiently expressed. As one example of such a composition, an approach which introduces an ethynyl group, which is a heat-crosslinking group, into the end of a PBO precursor polymer has been proposed. However, with heat treatment at a temperature even lower than 250˚C, for instance, the cyclodehydration reaction to the oxazole may itself not go to completion.

Accordingly, the present inventors considered that a heat treatment at a temperature that is just low enough to remove residual solvent from the relief pattern would be possible by using a composition which is a photosensitive resin composition that does not require a cyclodehydration reaction via a heat treatment, such as imidization or oxazolization, is soluble in an organic solvent and can be developed by an aqueous alkaline solution. Known examples of such a composition include compositions composed of a polyimide having a phenolic hydroxyl group and a PAC (e.g. Patent Documents 1 to 4), and compositions composed of a copolymer of an imide having a phenolic hydroxyl group and a benzoxazole having a carboxylic acid group, and a PAC (e.g. Patent Documents 5 and 6).

Patent Document 1 describes a composition comprising a polyimide formed by polycondensation of an aromatic tetracarboxylic acid component and an aromatic diamine component having at least one hydroxy substituent, and a

PAC. However, the PAC photosensitive efficiency is insufficient against the i-lines used in the fabrication step of a semiconductor device.

Patent Document 2 describes a composition comprising: a copolyimide composed of units formed by dehydration condensation of a tetracarboxylic acid component and a diamine component having at least one group selected from the group consisting of a phenolic hydroxyl group, a carboxyl group, a thiophenol group and a sulfonic group and units formed by dehydration condensation of a tetracarboxylic acid component and a diamine component which does not have a phenolic hydroxyl group, a carboxyl group, a thiophenol group or a sulfonic group; and a PAC. Although this composition has an improved optical transparency of the copolyimide as a result of using a specific compound for the tetracarboxylic acid component when the diamine component has a phenolic hydroxyl group or a thiophenol group, the PAC photosensitive efficiency is insufficient.

Patent Document 3 describes a composition composed of a solvent-soluble polyimide having a phenolic hydroxyl group, a polyamic acid having a silicone bond in the molecule, and a PAC. By adding a polyamic acid which has a silicone bond in the molecule, the composition has improved adhesion with the supporting substrate. However, with the described combination of a solvent-soluble polyimide having a phenolic hydroxyl group described and a PAC, photosensitive efficiency is insufficient. In addition, the thermal expansion coefficient of the obtained cured coating is high due to the inclusion of a polyamic acid component having a silicone bond in the molecule.

Patent Document 4 describes a composition composed of a polyimide formed by polycondensation of a cyclic tetracarboxylic acid component and a cyclic diamine acid component having two hydroxy substituents, and a PAC. However, the specific examples which obtained good properties were limited to cases using 50 mol% or more of hexafluoro-2,2-bis(3-amino-4-dihydroxyphenyl)propane as the cyclic diamine acid component and 3,3',4,4'-diphenylsulfone tetracarboxylic dianhydride as the cyclic tetracarboxylic acid component. Cases of using other tetracarboxylic acid components and diamine components are only described in the comparative examples.

In Patent Document 5, examples are described in which a composition composed of a solvent-soluble polycondensate and a PAC is irradiated with light rays on copper foil to cure the pattern, which is then developed with a 50% aqueous solution of aminoethanol. However, the photosensitive efficiency of such composition is insufficient.

In Patent Document 6, examples are described in which a composition composed of a solvent-soluble polycondensate and a PAC is coated on a silicon wafer and irradiated with light rays to cure the pattern, which is then developed with a 5% aqueous solution of tetramethylammonium hydroxide. Specifically, in Examples 2-2 to 2-8, a positive photosensitive resin composition is described which contains a polycondensate of a tetracarboxylic dianhydride and an aromatic diamine having an amino group and a phenolic hydroxyl group which are located at ortho positions with respect to each other, the composition having a ratio of tetracarboxylic dianhydride to aromatic diamine of 1:1 and a weight average molecular weight of 33,000 to 55,200. However, upon further investigation carried out by the present inventors, this composition had insufficient solubility in aqueous alkaline solution and the obtained pattern had a low resolution. In addition, the photosensitive efficiency of such composition which is combined with a PAC as described in the examples is insufficient.

Further, in the exposure step during fabrication of a semiconductor device, a reduced projection exposure apparatus known as a "stepper" is mainly used. This stepper is a very expensive machine, and thus if the photosensitive resin composition has a low sensitivity, the exposure time required to form the relief pattern lengthens, so that the number of required steppers increases, which leads to an increase in the costs of the exposure process. Therefore, there is a need to improve the photosensitivity of the photosensitive resin composition.

The following Patent Documents 7 to 12 are prior art describing the combination of a PBO precursor with a suitable PAC, and are cited in the below-described Best Mode for Carrying Out the Invention.

[Patent Document 1] JP-A-64-60630
[Patent Document 2] JP-A-3-209478
[Patent Document 3] JP-A-11-84653
[Patent Document 4] JP-A-2001-249454
[Patent Document 5] W02001/034679 Pamphlet
[Patent Document 6] W02003/060010 Pamphlet
[Patent Document 7] JP-A-2001-109149
[Patent Document 8] JP-A-2001-92138
[Patent Document 9] JP-A-2004-347902
[Patent Document 10] JP-A-2003-131368
[Patent Document 11] JP-A-2004-109849
[Patent Document 12] JP-A-2001-356475

DISCLOSURE OF THE INVENTION

It is an object of the present invention to provide a photosensitive resin composition which can obtain a high sensitivity, good relief pattern, and which can obtain a cured relief pattern by a low-temperature heat treatment. It is also an object of the present invention to provide a method for forming a cured relief pattern on a substrate by a low-temperature heat treatment using such composition, and a semiconductor device comprising such cured relief pattern.

The present inventors discovered that, to resolve the problems of Patent Document 6, while molecular weight can be lowered by shortening the reaction time when obtaining a solvent-soluble polycondensate having a structure formed from dehydration condensation of one or more tetracarboxylic dianhydrides and one or more aromatic diamines having at least two pairs of an amino group and a phenolic hydroxyl group which are located at ortho positions with respect to each other, with a 1:1 ratio between the tetracarboxylic dianhydride and the aromatic diamine, the storage stability of the polymer is insufficient. However, the present inventors discovered that storage stability and polymer solubility could be improved by varying the ratio between the tetracarboxylic dianhydride and the aromatic diamine to lower the molecular weight, whereby a high-resolution, good relief pattern could be obtained. As a result, the present inventors discovered that the above-described properties could be satisfied, thereby arriving at the present invention.

Specifically, one aspect of the present invention is a photosensitive resin composition comprising 1 to 100 parts by mass of photosensitive diazonaphthoquinone compound (B) based on 100 parts by mass of polycondensate (A), which has a structure formed from dehydration condensation of one or more tetracarboxylic dianhydrides and one or more aromatic diamines having an amino group and a phenolic hydroxyl group which are located at ortho positions with respect to each other, wherein the polycondensate (A) has a weight average molecular weight of 3,000 to 70,000.

The polycondensate (A) preferably has a structure formed from dehydration condensation of, as the tetracarboxylic dianhydride, at least one selected from the group consisting of bicyclo(2,2,2)-oct-7-ene-2,3,5,6-tetracarboxylic dianhydride, 2,2-bis(3,4-dicarboxyphenyl)hexafluoropropane dianhydride and bis(3,4-dicarboxyphenyl) ether dianhydride and, as the aromatic diamine, at least one selected from the group consisting of bis(3-amino-4-hydroxyphenyl) sulfone, 2,2-bis(3-amino-4-hydroxyphenyl)hexafluoropropane and 3,3'-dihydroxy-4,4'-diaminobiphenyl.

Among these, the polycondensate (A) preferably has a structure formed from dehydration condensation of a tetracarboxylic dianhydride comprising bicyclo(2,2,2)-oct-7-ene-2,3,5,6-tetracarboxylic dianhydride and an aromatic diamine comprising bis(3-amino-4-hydroxyphenyl)sulfone.

Even among these, especially preferred is where the polycondensate (A) has a structure formed from dehydration condensation of a tetracarboxylic dianhydride comprising bicyclo(2,2,2)-oct-7-ene-2,3,5,6-tetracarboxylic dianhydride and an aromatic diamine comprising bis(3-amino-4-hydroxyphenyl)sulfone, wherein during charging of the raw material the bis(3-amino-4-hydroxyphenyl)sulfone is in a range of 20 to 60 mol% of all the raw material monomers, and most preferred is where during charging of the raw material the bis(3-amino-4-hydroxyphenyl)sulfone is in a range of 20 to 40 mol% of all the raw material monomers, a ratio between the total number of moles of the tetracarboxylic dianhydride and the total number of moles of the diamine is in a range of 1:0.75 to 0.87 or 0.75 to 0.87:1, and the polycondensate has a weight average molecular weight in the range of 5,000 to 17,000.

Further, the photosensitive resin composition is preferably such that the photosensitive diazonaphthoquinone compound (B) is at least one compound selected from the group consisting of a 1,2-naphthoquinonediazide-4-sulfonate of a polyhydroxy compound represented by one of the following general formulae (1) to (6) and a 1,2-naphthoquinonediazide-5-sulfonate of the polyhydroxy compound represented by one of the following general formulae (1) to (6),

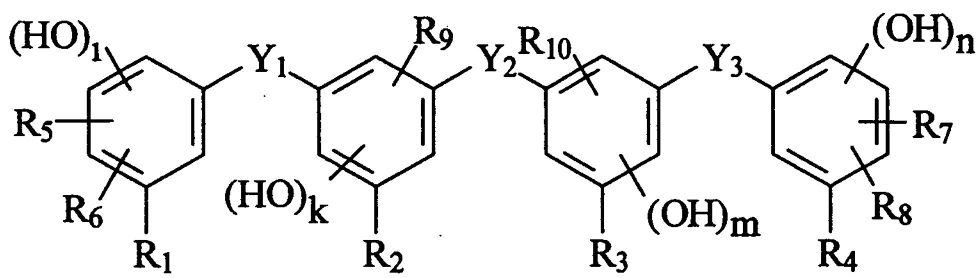

(1)

wherein k, 1, m and n each independently represent 1 or 2; $R_1$ to $R_{10}$ each independently represent at least one monovalent group selected from the group consisting of a hydrogen atom, a halogen atom, an alkyl group, an alkenyl group, an alkoxy group, an allyl group and an acyl group; and $Y_1$ to $Y_3$ each independently represent at least one divalent group selected from the group consisting of a single bond, -O-, -S-, -SO-, -$SO_2$--CO-, -$CO_2$- cyclopentylidene, cyclohex-

ylidene, phenylene and an organic group represented by the following chemical formulae,

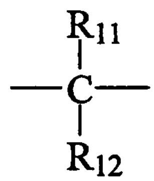

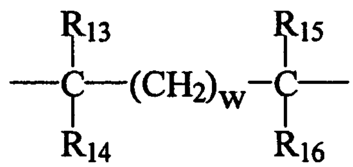

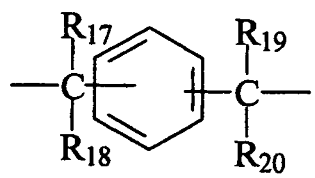

wherein $R_{11}$ and $R_{12}$ each independently represent at least one monovalent group selected from the group consisting of a hydrogen atom, an alkyl group, an alkenyl group, an allyl group and a substituted allyl group; $R_{13}$ to $R_{16}$ represent a hydrogen atom or an alkyl group which may be the same or different; w represents an integer of 1 to 5; and $R_{17}$ to $R_{20}$ represent a hydrogen atom or an alkyl group which may be the same or different;

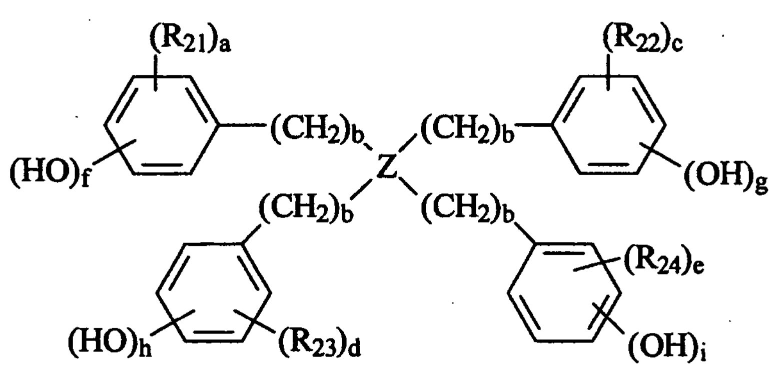

(2)

wherein Z represents at least one tetravalent group selected from the organic groups represented by the following chemical formulae; $R_{21}$, $R_{22}$, $R_{23}$ and $R_{24}$ each independently represent a monovalent organic group; b represents 0 or 1; a, c, d and e each independently represent an integer of 0 to 3; and f, g, h and i each independently represent an integer of 0 to 2;

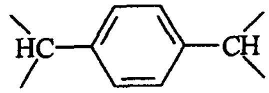

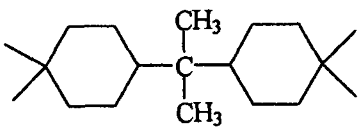

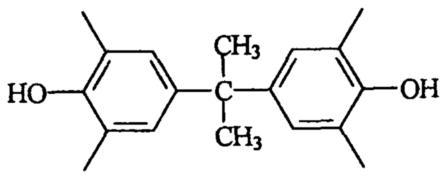

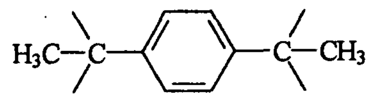

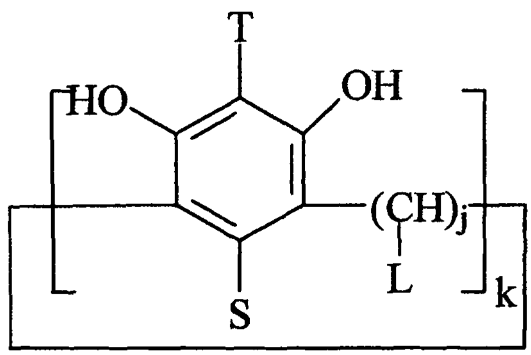

(3)

wherein k represents an integer of 3 to 8; k×j L's each independently represent a monovalent organic group having one or more carbon atoms; j represents an integer of 1 to 5; and k T's and k S's each independently represent a monovalent group selected from the group consisting of a hydrogen atom and a monovalent organic group;

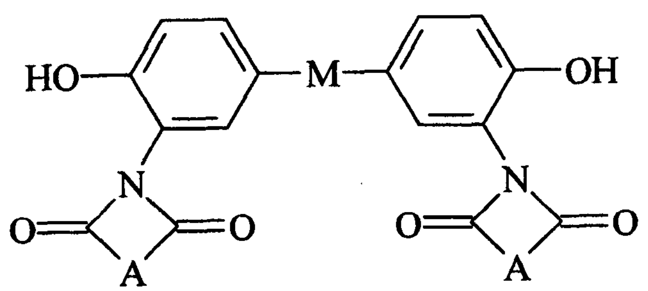

(4)

wherein A represents a divalent organic group containing an aliphatic tertiary or quaternary carbon atom; and M represents at least one divalent group selected from the groups represented by the following chemical formulae;

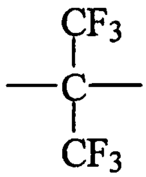

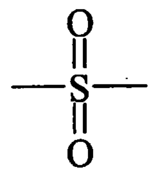

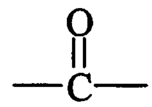

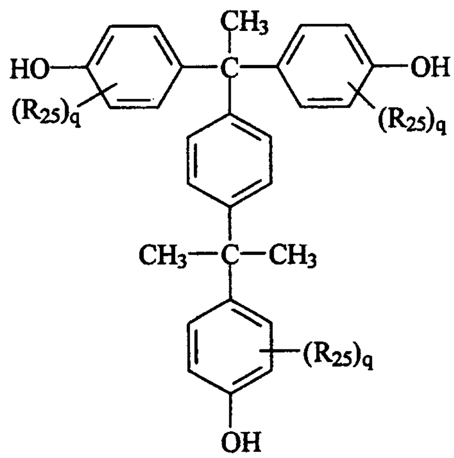

(5)

wherein each $R_{25}$ represents a monovalent group represented by the following chemical formula, and may be the same or different; and each q independently represents an integer of 0 to 2,

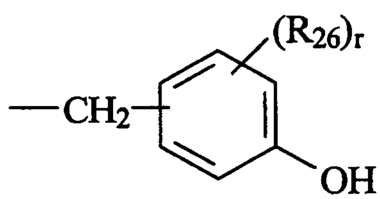

wherein each $R_{26}$ independently represents at least one monovalent organic group selected from the group consisting of an alkyl group and a cycloalkyl group; and each r independently represents an integer of 0 to 2; and

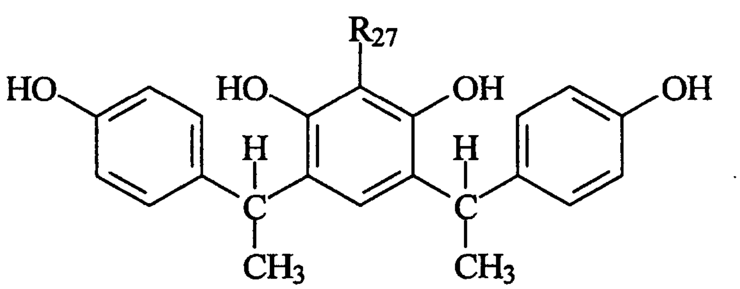

(6)

wherein $R_{27}$ represents at least one monovalent organic group selected from the group consisting of a hydrogen atom,

an alkyl group, an alkoxy group and a cycloalkyl group.

Another aspect of the present invention is a method for forming a cured relief pattern, comprising a coating step for forming the above-described photosensitive resin composition on a substrate in a form of a layer or a film, an exposure step for exposing the layer or film with actinic rays through a mask or for directly irradiating the layer or film with light rays, an electron beam or an ion beam, a developing step for eluting or removing the exposed portions or irradiated portions with a developing solution, and a heating step for heating an obtained relief pattern.

Another aspect of the present invention is a semiconductor device comprising the cured relief pattern obtained by the above-described formation method.

The composition according to the present invention is a photosensitive resin composition which can obtain a high sensitivity, good relief pattern which is free from swelling during the developing step with a developing solution (aqueous solution of tetramethylammonium hydroxide) generally used in the fabrication step of a semiconductor device, which is cured by a heat treatment at 300˚C or less. Further, the present invention can provide a method for forming a cured relief pattern on a substrate by a low-temperature heat treatment of the composition, and a semiconductor device comprising the cured relief pattern.

BRIEF DESCRIPTION OF THE DRAWINGS

Fig. 1 shows the 13C-NMR spectra measurement results of the polymer synthesized in Reference Example 5;
Fig. 2 shows the 13C-NMR spectra measurement results of the polymer synthesized in Reference Example 7;
Fig. 3 shows the 13C-NMR spectra measurement results of the polymer synthesized in Reference Example 8;
Fig. 4 shows the 13C-NMR spectra measurement results of the polymer synthesized in Reference Example 9;
Fig. 5 shows the 13C-NMR spectra measurement results of the polymer synthesized in Reference Example 10; and
Fig. 6 shows the 13C-NMR spectra measurement results of the polymer synthesized in Reference Example 11.

BEST MODE FOR CARRYING OUT THE INVENTION

<Photosensitive resin composition>

The components constituting the photosensitive resin composition according to the present invention (hereinafter sometimes referred to as "present composition") will now be described.

[Polycondensate (A)]

The polycondensate (A) used in the present invention (hereinafter sometimes simply referred to as "polycondensate A") has a structure formed from dehydration condensation of one or more tetracarboxylic dianhydrides and one or more aromatic diamines having an amino group and a phenolic hydroxyl group which are located at ortho positions with respect to each other.

The tetracarboxylic dianhydride is preferably at least one compound selected from the group consisting of aromatic tetracarboxylic dianhydrides having 10 to 36 carbon atoms and alicyclic tetracarboxylic dianhydrides having 8 to 34 carbon atoms.

Specific examples include 3,4,3',4'-biphenyltetracarboxylic dianhydride, 2,3,3',4'-biphenyltetracarboxylic dianhydride, 3,4,3',4'-benzophenonetetracarboxylic dianhydride, bicyclo(2,2,2)-oct-7-ene-2,3,5,6-tetracarboxylic dianhydride, 2,2-bis(3,4-dicarboxyphenyl)propane dianhydride, bis(3,4-dicarboxyphenyl)sulfone dianhydride, bis(3,4-dicarboxyphenyl) ether dianhydride, cyclobutanetetracarboxylic dianhydride and 2,2-bis(3,4-dicarboxyphenyl)hexafluoropropane dianhydride. These tetracarboxylic dianhydrides can be used alone or in combination of two or more. In the above, among the tetracarboxylic dianhydrides, 2,2-bis(3,4-dicarboxyphenyl)hexafluoropropane dianhydride, bicyclo(2,2,2)-oct-7-ene-2,3,5,6-tetracarboxylic dianhydride and bis(3,4-dicarboxyphenyl) ether dianhydride are especially preferable due to having high solubility in the organic solvent of polycondensate A and high transparency to the i-lines which are normally used as the exposure light source.

The aforementioned aromatic diamine having an amino group and a phenolic hydroxyl group which are located at ortho positions with respect to each other (hereinafter sometimes referred to as "phenolic diamine"), specifically, the phenolic diamine used here, has one hydroxyl group in the aromatic ring (specifically, a phenolic hydroxyl group) and one amino group in an ortho position to the phenolic hydroxyl group, and further has another amino group in a separate position. Preferably, this aromatic diamine has 6 to 30 carbon atoms with at least two pairs of amino groups and phenolic hydroxyl groups which are located at ortho positions with respect to each other.

Specific examples include 3,5-diamino-1-hydroxybenzene, 4,6-diamino-1,3-dihydroxybenzene, 3,3'-dihydroxy-4,4'-diaminobiphenyl, 4,4'-dihydroxy-3,3'-diaminobiphenyl, 3,4-dihydroxy-3',4'-diaminobiphenyl, 2,2-bis(4-amino-3-hydroxyphenyl)propane, bis(3-amino-4-hydroxyphenyl)sulfide, bis(3-amino-4-hydroxyphenyl)sulfone, bis(3-amino-4-hydroxyphenyl)methane, bis(4-amino-3-hydroxyphenyl)methane, 2,2-bis(4-amino-3-hydroxyphenyl)hexafluoropropane, 2,2-bis(3-amino-4-hydroxyphenyl)hexafluoropropane, 2-(3hydroxy-4-aminophenyl)-2-(3-amino-4-hydroxyphenyl)hexafluoropropane, bis(3-amino-4-hydroxyphenyl)sulfone and bis(4-amino-3-hydroxyphenyl)sulfone. These phenolic diamines can be used alone or in combination of two or more. In the above, among the phenolic diamines, 2,2-bis(3-amino-4-hydroxyphenyl)hexafluoropropane, 3,3'-dihydroxy-4,4'-diaminobiphenyl and bis(3-amino-4-hydroxyphenyl) sulfone are especially preferable due to having high solubility in the alkaline developing solution of polycondensate A.

Especially preferred examples of the polycondensate A used in the present composition include combinations of a tetracarboxylic dianhydride comprising at least one selected from the group consisting of bicyclo(2,2,2)-oct-7-ene-2,3,5,6-tetracarboxylic dianhydride, 2,2-bis(3,4-dicarboxyphenyl)hexafluoropropane dianhydride and bis(3,4-dicarboxyphenyl) ether dianhydride and an aromatic diamine (phenolic diamine) comprising at least one selected from the group consisting of bis(3-amino-4-hydroxyphenyl)sulfone, 2,2-bis(3-amino-4-hydroxyphenyl)hexafluoropropane and 3,3'-dihydroxy-4,4'-diaminobiphenyl.

Further, a polycondensate having a polycondensation structure wherein the tetracarboxylic dianhydride is bicyclo(2,2,2)-oct-7-ene-2,3,5,6-tetracarboxylic dianhydride and the phenolic diamine is bis(3-amino-4-hydroxyphenyl) sulfone is most preferred, as such compound has high solubility in the organic solvent, high transparency to the exposure light source and a low thermal expansion coefficient of the cured film, as well as having a high solubility in the alkaline developing solution and good resolution performance of the relief pattern.

The dehydrating condensation reaction can be carried out, for example, according to the method described in Patent Document 5, by heating the above-described tetracarboxylic dianhydride and phenolic diamine in the presence of an acid or base catalyst to 30 to 220˚C, and preferably to 170 to 200˚C. Examples of acid catalysts which can be used include inorganic acids such as sulfuric acid and organic acids such as p-toluenesulfonic acid, which are usually used for the production of polyimides. However, these acid catalysts remain in the polycondensate solution after completion of the reaction, which may cause the degradation of the composition according to the present invention. Therefore, it is necessary to remove these catalysts by precipitating and re-dissolving the polycondensate.

Thus, in the production of polycondensate A, as the acid catalyst, it is preferred to employ an acid group generated in situ by carrying out the above-described dehydration condensation in the presence of a lactone-base catalyst. Specifically, as the acid catalyst it is preferred to employ a catalytic system utilizing the following equilibrium reaction between a lactone, a base and water.

$$\{Lactone\} + \{Base\} + \{Water\} = \{Acid\ group\}^{+}\{Base\}^{-}$$

Dehydration condensation may be carried out with the $\{acid\}^{+}\{base\}^{-}$ system as the catalyst. The produced water is eliminated from the reaction system by azeotropic distillation with toluene. When the imidization in the reaction system is finished, the $\{acid\}^{+}\{base\}^{-}$ is converted to the lactone and the base, whereby they lose their catalytic activity and are removed from the reaction system with the toluene. The polycondensate A solution produced by this method can be industrially used as is as a polycondensate solution with high purity because the above-described catalytic substances are not contained in the polyimide solution after the reaction.

As the lactone used here, γ-valerolactone is preferred. As the base, pyridine and/or methylmorpholine is(are) preferred used.

In addition, more preferred is a method without especially adding a polycondensation catalyst or the like, in which the temperature of the reaction solution is maintained equal to or higher than the temperature at which an imidization reaction occurs, wherein water produced by the dehydration reaction is eliminated from the reaction system by azeotropic distillation of the solvent with the water to complete the imidization dehydration condensation reaction. The polycondensate A solution produced by this method can also be industrially used as is as a polycondensate solution with high purity because the catalytic substances are not contained in the polyimide solution after the reaction.

Preferred reaction solvents used for the dehydration condensation reaction include, in addition to toluene, which is a solvent for organic azeotropic distillation with water, polar organic solvents for dissolving the polycondensate A. Examples of such a polar solvent include γ-butyrolactone, N-methylpyrrolidone, dimethylformamide, dimethylacetamide, tetramethylurea and sulfolane.

In cases where the above-mentioned lactone-base catalyst is used, based on the total reaction mixture at the beginning of the reaction, the concentration of the tetracarboxylic dianhydride is preferably about 4 to 25% by weight, the concentration of the lactone is preferably about 0 to 0.6% by weight and the concentration of the base is preferably

about 0 to 0.9% by weight.

In polycondensate A, the physical properties can be more appropriately controlled by forming the polycondensate by copolycondensing a tetracarboxylic dianhydride with the above-described phenolic diamine and the diamine which does not have a phenolic hydroxyl group (hereinafter referred to as "non-phenolic diamine"). Examples of the the non-phenolic diamine include an aromatic diamine which has 6 to 30 carbon atoms and does not have a phenolic hydroxyl group, and a diaminopolysiloxane.

Specific examples of the non-phenolic diamine include aromatic diamines such as 4,4'-(or 3,4'-, 3,3'-, 2,4'-) diaminodiphenyl ether, 4,4'-(or 3,3'-)diaminodiphenyl sulfone, 4,4'-(or 3,3'-)diaminodiphenyl sulfide, 4,4'-benzophenonediamine, 3,3'-benzophenonediamine, 4,4'-di(4-aminophenoxy)phenyl sulfone, 4,4'-di(3-aminophenoxy)phenyl sulfone, 4,4'-bis(4-aminophenoxy)biphenyl, 1,4-bis(4-aminophenoxy)benzene, 1,3-bis(4-aminophenoxy)benzene, 2,2-bis{4-(4-aminophenoxy)phenyl}propane, 3,3',5,5'-tetramethyl-4,4'-diaminodiphenylmethane, 2,2'-bis(4-aminophenyl)propane, 2,2'-trifluoromethyl-4,4'-diaminobiphenyl, 2,2',6,6'-tetramethyl-4,4'-diaminobiphenyl, 2,2',6,6'-tetratrifluoromethyl-4,4'-diaminobiphenyl, bis{(4-aminophenyl)-2-propyl}1,4-benzene, 9,9-bis(4-aminophenyl)fluorene, 9,9-bis(4-aminophenoxyphenyl)fluorene, 3,3'-dimethylbenzidine, 3,3'-dimethoxybenzidine and 3,5-diaminobenzoic acid, diamines such as 2,6-diaminopyridine, 2,4-diaminopyridine, bis(4-aminophenyl-2-propyl)-1,4-benzene and diaminopolysiloxane compounds. The non-phenolic diamine can be used alone or in combination of two or more.

In general, polyimide resins having a high modulus of elasticity are straight rigid polymers which have a low solubility in solvents, and often have a low transparency to i-lines. Therefore, it is important to design the polymer so as to have a molecular alignment which meets demanded properties contradicting each other, i.e., solubility in the solvent and high modulus of elasticity. To this end, the polycondensate A is preferably a block copolycondensate having a defined molecular alignment composed of blocks formed by polycondensation of a phenolic diamine and a tetracarboxylic dianhydride and blocks formed by polycondensation of a non-phenolic diamine and a tetracarboxylic dianhydride.

If using a block copolymer, in the blocks formed by polycondensation of a non-phenolic diamine and a tetracarboxylic dianhydride, an aromatic tetracarboxylic acid is preferable from the standpoint of obtaining high elasticity. On the other hand, from the standpoint of solubility in the solvent and transparency to i-lines, an aliphatic tetracarboxylic acid is preferred, and bicyclo(2,2,2)-oct-7-ene-2,3,5,6-tetracarboxylic dianhydride is especially preferred. From the standpoint of obtaining a polymer with an aromatic diamine having high elasticity, a non-phenolic diamine is preferred.

Further, as a block formed by the polycondensation of a phenolic diamine and a tetracarboxylic dianhydride, a block having a structure formed by the polycondensation of a tetracarboxylic dianhydride, which is at least one compound selected from the group consisting of 2,2-bis(3,4-dicarboxyphenyl)hexafluoropropane dianhydride, bicyclo(2,2,2)-oct-7-ene-2,3,5,6-tetracarboxylic dianhydride and bis(3,4-dicarboxyphenyl) ether dianhydride, and a phenolic diamine, which is at least one compound selected from the group consisting of 2,2-bis(3-amino-4-hydroxyphenyl)hexafluoropropane, 3,3'-dihydroxy-4,4'-diaminobiphenyl and bis(3-amino-4-hydroxyphenyl)sulfone, is preferred from the standpoint of solubility in aqueous alkaline solution, transparency to i-lines and solubility in the solvent. Among these, a polycondensate having a structure formed by the dehydration condensation of bicyclo(2,2,2)-oct-7-ene-2,3,5,6-tetracarboxylic dianhydride and bis(3-amino-4-hydroxyphenyl)sulfone, wherein the bis(3-amino-4-hydroxyphenyl)sulfone is in the range of 20 to 60 mol% of the total of the raw material monomers, is preferred due to having solubility in the organic solvent and transparency to i-lines, as well as having high developability when a 2.38% aqueous solution of tetramethylammonium hydroxide, which is the developing solution that is generally used in the fabrication step of a semiconductor device, is used, and a low thermal expansion coefficient of the cured film.

Forming condensate A into the block copolycondensate can be achieved through a two-stage polycondensation method in which excess tetracarboxylic dianhydride is reacted with a phenolic diamine during the above-described condensation reaction to obtain blocks, and then the non-phenolic diamine is added (so that the mole ratio between the total of the phenolic diamine and non-phenolic diamine and the tetracarboxylic dianhydride is 1:1.5 to 0.7). In this case, the order of adding the non-phenolic diamine and phenolic diamine may be changed. Variations of this process are specifically described in the following examples. A copolycondensate having 4 or more components may be produced by increasing the number of times of successively adding each monomer.

Obviously, the block copolycondensate can also be formed using two or more tetracarboxylic dianhydrides or two or more phenolic diamines. Further, the present invention is not limited to a block copolycondensate using successive reactions. In the case of charging three or more raw materials, the raw materials may be charged simultaneously into the reaction system to form a random copolycondensate.

The ends of the polycondensate A may also be modified with an organic group having an unsaturated bond. Modification of the ends of the polycondensate A can be carried out by adding a suitable amount of maleic anhydride, succinic anhydride, cinnamic anhydride, norbornene anhydride, 4-ethynylphthalic anhydride, phenylethynylphthalic anhydride, 4-aminostyrene, 4-ethynylaniline or 3-ethynylaniline during the synthesis of the polycondensate A.

Regarding the polycondensate A weight average molecular weight and developing solution, the weight average molecular weight is preferably 3,000 to 70,000 in terms of polystyrene and the polycondensate preferably is such that it can be developed by an aqueous solution of ethanolamine, a 5% aqueous solution of tetramethylammonium hydroxide

or a 2.38% aqueous solution of tetramethylammonium hydroxide. More preferably, when the polycondensate has a structure formed from dehydration condensation of bicyclo(2,2,2)-oct-7-ene-2,3,5,6-tetracarboxylic dianhydride and bis (3-amino-4-hydroxyphenyl)sulfone, wherein the bis(3-amino-4-hydroxyphenyl)sulfone is in the range of 20 to 60 mol% of the total of the raw material monomers, the weight average molecular weight is 5,000 to 17,000 in terms of polystyrene. If the molecular weight is 5,000 or more, mechanical properties are improved, and if the molecular weight is 17,000 or less, dispersibility in a 2.38% aqueous solution of tetramethylammonium hydroxide and the resolution performance of the relief pattern are improved. To control the weight average molecular weight, the reaction is preferably carried out so that the molar ratio between all of the tetracarboxylic dianhydride and the total of the phenolic diamine and non-phenolic diamine is 1:0.75 to 0.87, or 0.75 to 0.87:1, and particularly more preferably 1:0.75 to 0.87. As described above, while it is possible to control by charging in a 1:1 ratio, and shortening the reaction time, in this case the room temperature storage stability of the composition is not good.

Since the polycondensate A produced according to the above-described method is obtained in liquid form in the organic solvent (hereinafter sometimes referred to as "polycondensate solution" or "polymer solution"), the composition according to the present invention may also be produced by adding the below-described photosensitive diazonaphthoquinone compound (B) thereto.

The polycondensate A concentration in the polycondensate solution is preferably 5 to 50% by weight. The solution may also be further diluted with the below-described organic solvent (C), if desired.

Further, the produced polycondensate solution does not have to be used as is, and may be used by subjecting it to a purifying step to isolate the polycondensate and then redissolving again in the above-described organic solvent (C). A specific example of the purifying method is to first charge a poor solvent such as methanol, ethanol, isopropanol or water into the polycondensate solution obtained by the above-described production method to precipitate the polycondensate. Next, the obtained product is redissolved in a good solvent, such as γ-butyrolactone or N-methylpyrrolidone. The dissolved solution is passed through a column filled with ion-exchange resin to remove ionic impurities. Finally, the dissolved solution is charged into pure water, the resultant precipitate is filtrated and the obtained product is dried under vacuum. As a result of this purifying method, low-molecular weight components and ionic impurities and the like can also be eliminated. [Photosensitive diazonaphthoquinone compound (B)]

The photosensitive diazonaphthoquinone compound (B) used in the present composition (hereinafter referred to as "NQD compound B") is at least one compound selected from the group consisting of a 1,2-naphthoquinonediazide-4-sulfonate of a polyhydroxy compound having the below-described specific structure and a 1,2-naphthoquinonediazide-5-sulfonate of such polyhydroxy compounds.

This NQD compound B can be obtained by forming a naphthoquinone diazide compound as a sulfonyl chloride using chlorosulfonic acid or thionyl chloride according to a common method, and subjecting the obtained naphthoquinone diazide sulfonyl chloride to a condensation reaction with a polyhydroxy compound. For example, the NQD compound B can be obtained by esterifying, in the presence of a basic catalyst such as triethylamine, predetermined amounts of a polyhydroxy compound and 1,2-naphthoquinonediazide-5-sulfonyl chloride or 1,2-naphthoquinonediazide-4-sulfonyl chloride, in a solvent such as dioxane, acetone or tetrahydrofuran, then washing and drying the product.

The NQD compound B which, in the present composition, can be combined with the polycondensate A to obtain a good relief pattern which expresses high sensitivity and does not swell from an alkaline developing solution, will be described below.

(1) NQD compounds of the polyhydroxy compound represented by the following general formula (1)

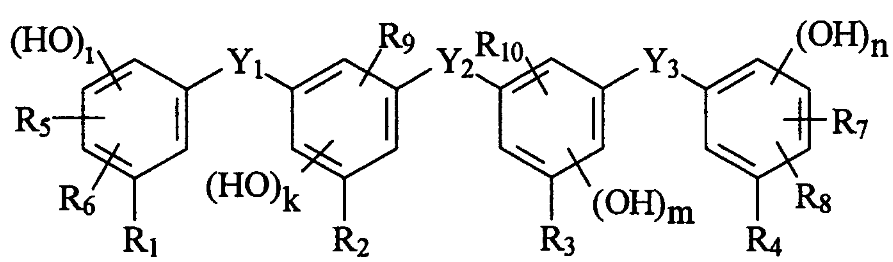

(1)

In formula (1), k, 1, m and n each independently represent 1 or 2; $R_1$ to $R_{10}$ each independently represent at least one monovalent group selected from the group consisting of a hydrogen atom, a halogen atom, an alkyl group, an alkenyl group, an alkoxy group, an allyl group and an acyl group; and $Y_1$ to $Y_3$ each independently represent at least one divalent group selected from the group consisting of a single bond, -O-, -S-, -SO-, $-SO_2-$, -CO-, $-CO_2-$,

cyclopentylidene, cyclohexylidene, phenylene and an organic group represented by the following chemical formulae,

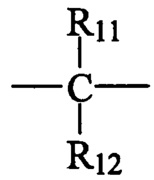

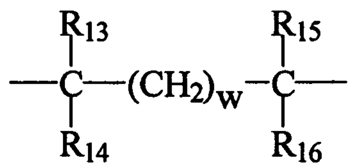

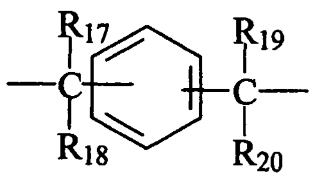

wherein $R_{11}$ and $R_{12}$ each independently represent at least one monovalent group selected from the group consisting of a hydrogen atom, an alkyl group, an alkenyl group, an allyl group and a substituted allyl group; $R_{13}$ to $R_{16}$ represent a hydrogen atom or an alkyl group which may be the same or different; w represents an integer of 1 to 5; and $R_{17}$ to $R_{20}$ represent a hydrogen atom or an alkyl group which may be the same or different.

Specific examples of the compounds include the NQD compounds of a polyhydroxy compound described in Patent Document 7. Among those, NQD compounds of the following polyhydroxy compound are preferred, as they have high sensitivity and hardly precipitate in the photosensitive resin composition.

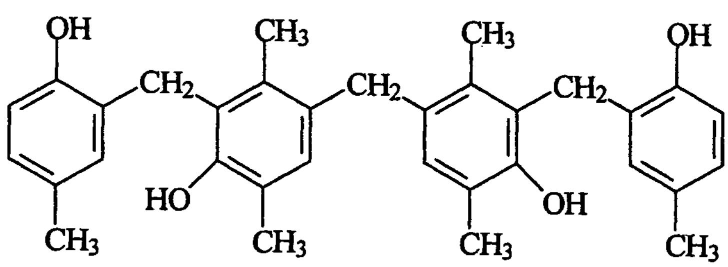

(2) NQD compounds of the polyhydroxy compound represented by the following general formula (2)

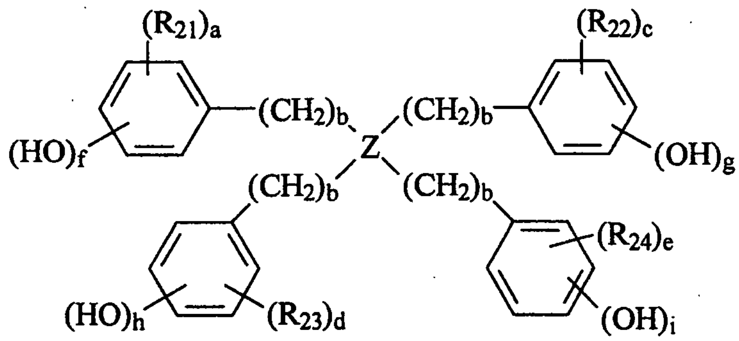

(2)

In formula (2), Z represents at least one tetravalent group selected from the organic groups represented by the following chemical formulae; $R_{21}$, $R_{22}$, $R_{23}$ and $R_{24}$ each independently represent a monovalent organic group; b represents 0 or 1; a, c, d and e each independently represent an integer of 0 to 3; and f, g, h and i each independently represent an integer of 0 to 2.

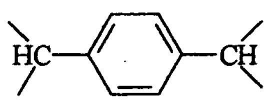

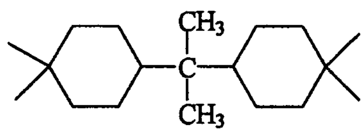

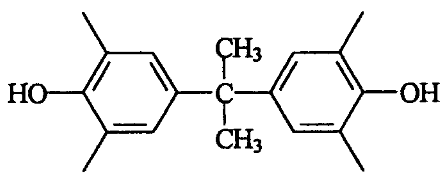

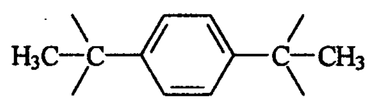

Specific examples of the compounds are described in Patent Document 8. Among those, NQD compounds of the following polyhydroxy compounds are preferred, as they have high sensitivity and hardly precipitate in the photosensitive resin composition.

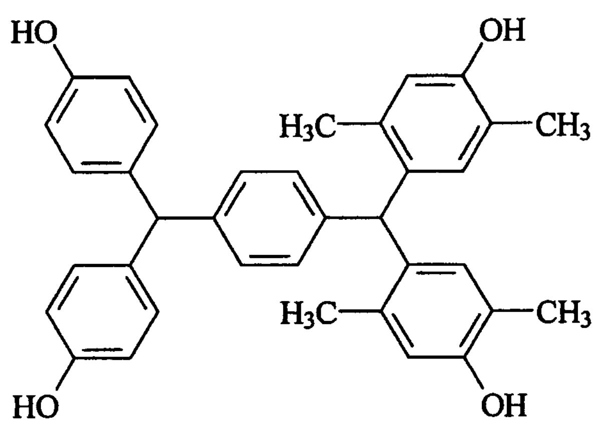

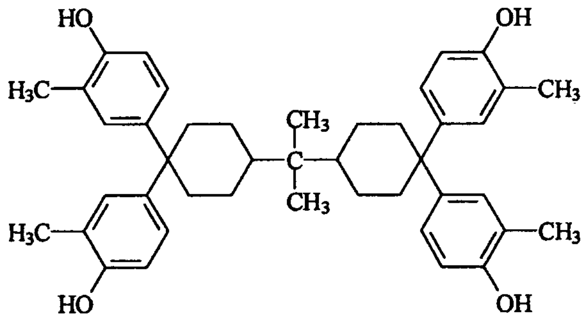

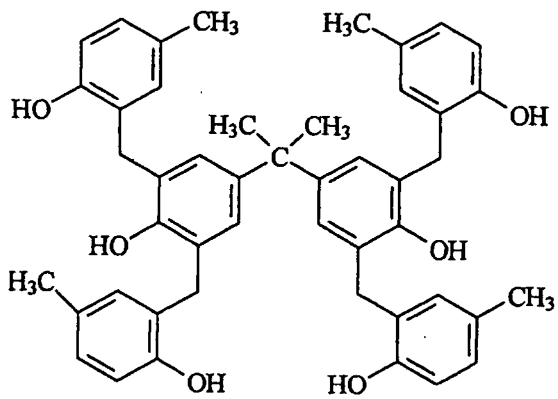

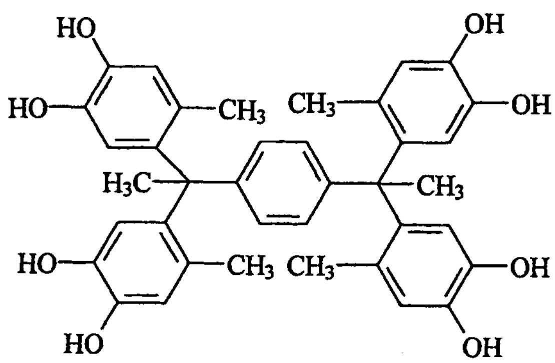

(3) NQD compounds of the polyhydroxy compound represented by the following general formula (3)

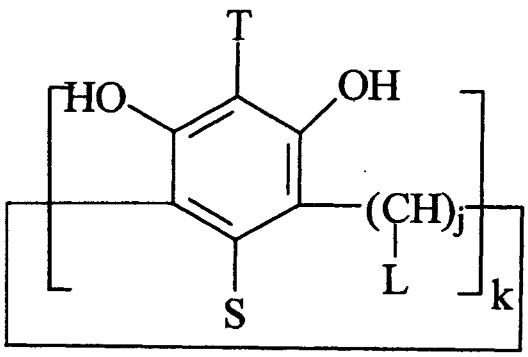

(3)

In formula (3), k represents an integer of 3 to 8; kxj L's each independently represent a monovalent organic group having one or more carbon atoms; j represents an integer of 1 to 5; and k T's and k S's each independently represent a monovalent group selected from the group consisting of a hydrogen atom and a monovalent organic group.

Specific preferred examples are described in Patent Document 9. Among those, NQD compounds of the following compound are preferred, as they have high sensitivity and hardly precipitate in the photosensitive resin composition.

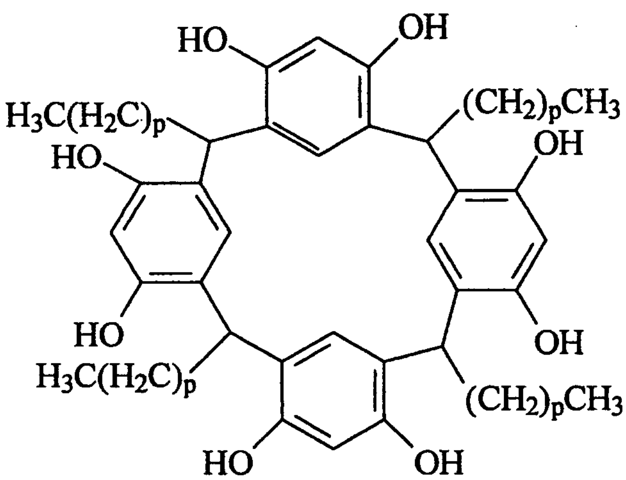

(wherein p represents an integer of 0 to 9)

(4) NQD compounds of the polyhydroxy compound represented by the following general formula (4)

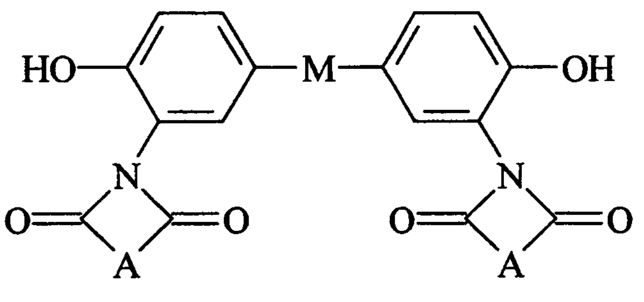

(4)

In formula (4), A represents a divalent organic group containing an aliphatic tertiary or quaternary carbon atom; and M represents at least one divalent group selected from the groups represented by the following chemical formulae.

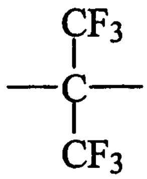 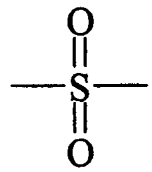 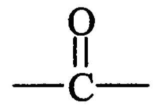

Specific examples of the compounds are described in Patent Document 10. Among those, NQD compounds of the following compounds are preferred, as they have high sensitivity and hardly precipitate in the photosensitive resin composition.

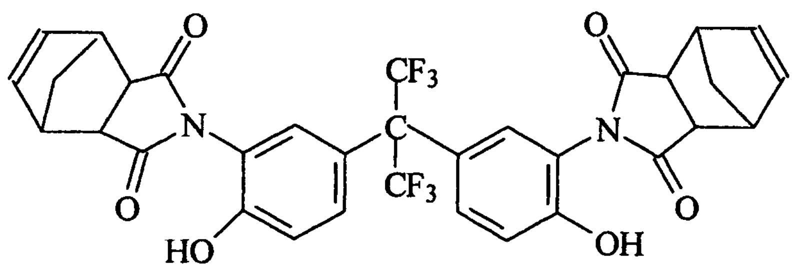

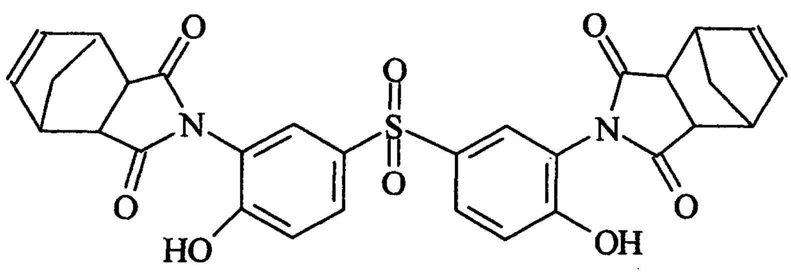

(5) NQD compounds of the polyhydroxy compound represented by the following general formula (5)

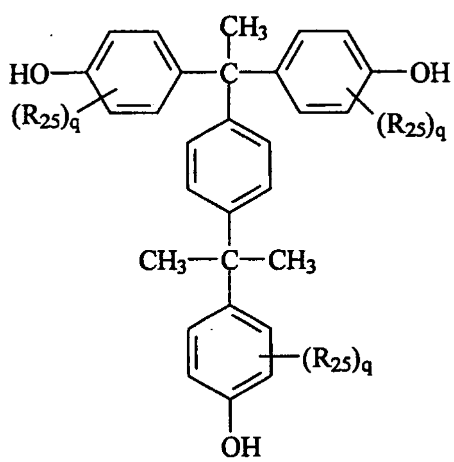

(5)

In formula (5), each $R_{25}$ represents a monovalent group represented by the following chemical formula, and may be the same or different; and each q independently represents an integer of 0 to 2,

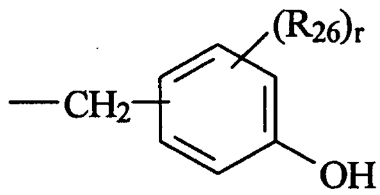

wherein each $R_{26}$ independently represents at least one monovalent organic group selected from the group consisting of an alkyl group and a cycloalkyl group; and each r independently represents an integer of 0 to 2.
Specific examples of the compounds include the NQD compounds of a polyhydroxy compound described in Patent Document 11. Among those, NQD compounds of the following compounds are preferred, as they have high sensitivity and hardly precipitate in the photosensitive resin composition.

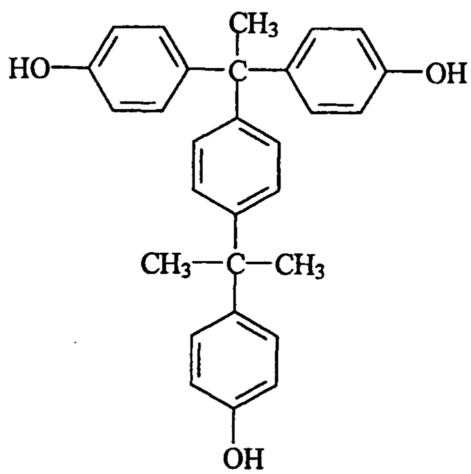

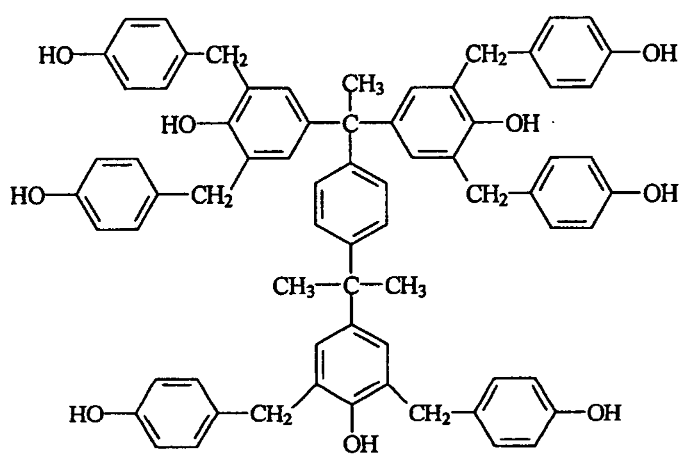

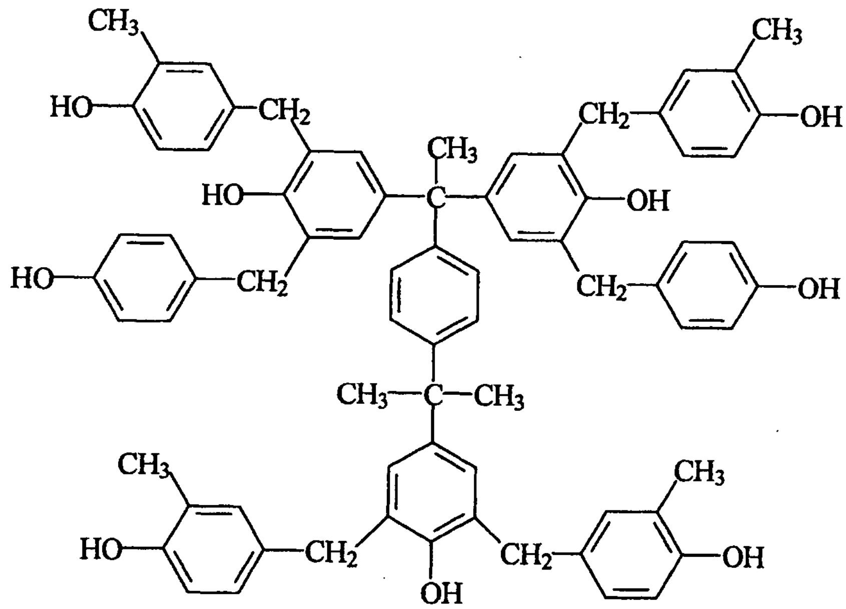

(6) NQD compounds of the polyhydroxy compound represented by the following general formula (6)

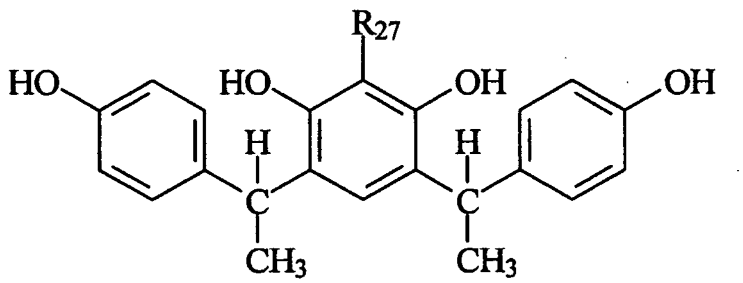

(6)

In formula (6), $R_{27}$ represents at least one monovalent organic group selected from the group consisting of a hydrogen atom, an alkyl group, an alkoxy group and a cycloalkyl group.

Specific examples of the compounds are described in Patent Document 12. Among those, NQD compounds of the following compound are preferred, as they have high sensitivity and hardly precipitate in the photosensitive resin composition.

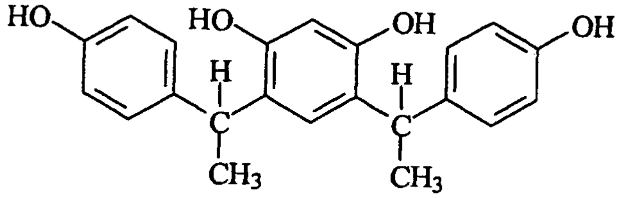

In the present composition, either a 5-naphthoquinone diazidesulfonyl group or a 4-naphthoquinone diazidesulfonyl group can be used for the naphthoquinone diazide sulfonyl group in the NQB compound B. 4-Naphthoquinone diazidesulfonyl ester compounds have absorbance in the i-line region of a mercury lamp, and are thus suitable for i-line

exposure. 5-Naphthoquinone diazidesulfonyl ester compounds have absorbance extending as far as the g-line region of a mercury lamp, and are thus suitable for g-line exposure. In the present invention, it is preferable to select 4-naphthoquinone diazidesulfonyl ester compound or 5-naphthoquinone diazidesulfonyl ester compound according to the wavelength for exposure. Further, a naphthoquinone diazidesulfonyl ester compound can be obtained in which a 4-naphthoquinone diazidesulfonyl group and a 5-naphthoquinone diazidesulfonyl group are combined in the same molecule. In addition, a 4-naphthoquinone diazidesulfonyl ester compound and a 5-naphthoquinone diazidesulfonyl ester compound may be mixed together for use.

In the present composition, the amount of the NQD compound is in the range of, based on 100 parts by mass of the polycondensate A, 1 to 100 parts by mass, preferably 3 to 40 parts by mass and more preferably 10 to 30 parts by mass.

[Organic solvent (C)]

Examples of the organic solvent (C) used in the present composition include the polar solvents N-methyl-2-pyrrolidone, N,N-dimethylacetamide, N,N-dimethylformamide, dimethyl sulfoxide, tetramethylurea, γ-butyrolactone and morpholine. In addition to these polar solvents, common organic solvents, such as ketones, esters, lactones, ethers, halogenated hydrocarbons and hydrocarbons may also be mixed. Examples which can be used include acetone, methyl ethyl ketone, methyl isobutyl ketone, cyclohexanone, methyl acetate, ethyl acetate, butyl acetate, diethyl oxalate, ethyl lactate, methyl lactate, butyl lactate, propylene glycol monomethyl ether acetate, propylene glycol monomethyl ether, benzyl alcohol, phenyl glycol, ethylene glycol dimethyl ether, diethylene glycol dimethyl ether, tetrahydrofuran, dichloromethane, 1,2-dichloroethane, 1,4-dichlorobutane, chlorobenzene, o-dichlorobenzene, anisole, hexane, heptane, benzene, toluene, xylene and mesitylene.

In the present composition, the amount of the organic solvent (C) is in the range of, based on 100 parts by mass of the polycondensate A, 100 to 1,000 parts by mass, preferably 120 to 700 parts by mass and more preferably 150 to 500 parts by mass.

[(D) Other Additives]

In the photosensitive resin composition according to the present invention, additives such as a dye, a surfactant and a stabilizer may optionally be used. These additives will now be described in more detail. Examples of the dye include methyl violet, crystal violet and malachite green. Examples of the surfactant include a non-ionic surfactant consisting of a polyglycol such as polypropylene glycol or polyoxyethylene lauryl ether, or a derivative thereof, a fluorine surfactant such as Florard (trade name, manufactured by Sumitomo 3M Ltd.), Megafac (trade name, manufactured by Dainippon Ink And Chemicals, Incorporated), or Sulfron (trade name, manufactured by Asahi Glass Co., Ltd.), and an organic siloxane surfactant such as KP341 (trade name, manufactured by Shin-Etsu Chemical Co., Ltd.), DBE (trade name, manufactured by Chisso Corporation), or Glanol (trade name, manufactured by Kyoeisha Chemical Co., Ltd.).

<Method for forming cured relief pattern>

One example of the method for forming a cured relief pattern on a substrate using the present composition (hereinafter sometimes referred to as "present method") will now be described.

First, a coating step is carried out for forming the present composition on a substrate in the form of a layer or a film. Examples of the substrate on which the coating is carried out include a silicon wafer, a ceramic substrate or an aluminum substrate. At this stage, a bonding auxiliary such as a silane coupling agent may be coated in advance onto the substrate in order to improve adhesion between the relief pattern to be formed and the substrate. Examples of the coating method include spin-coating using a spinner, spray coating using a spray coater, dipping, printing and roll coating.

Then, the coating is dried by prebaking at 80 to 140˚C, followed by carrying out an exposure step for exposing the layer or film with actinic rays through a mask using an exposure apparatus such as a contact aligner, a mirror projector or a stepper, or for directly irradiating the layer or film with light rays, an electron beam or an ion beam. Examples of the actinic rays which may be used include X-rays, an electron beam, UV rays, or visible light rays, but the rays preferably have a wavelength of 200 to 500 nm. From the standpoint of pattern resolution and handleability, the light source wavelength is preferably the g-lines, h-lines or i-lines of a mercury lamp. Such rays may be used singly or in combination. Especially preferred as the exposure apparatus is a contact aligner, a mirror projector or a stepper.

Next, a developing step is carried out for eluting or removing the exposed portions or irradiated portions with a developing solution. The developing method can be selected from dipping, paddling and rotational spraying. Examples of the developing solution include inorganic alkalis such as sodium hydroxide, sodium carbonate, sodium silicate and ammonia water, organic amines such as ethylamine, diethylamine, triethylamine and triethanolamine, an aqueous solution of a quaternary ammonium salt such as tetramethylammonium hydroxide and tetrabutylammonium hydroxide,

and an aqueous solution into which a suitable amount of water-soluble organic solvent such as methanol or ethanol and a surfactant are optionally added. Among these, an aqueous solution of tetramethylammonium hydroxide is preferred, having a concentration of 0.5 to 10% and more preferably 1.0 to 5.0%. After developing, washing is carried out with a rinsing solution to remove the developing solution, whereby a relief pattern formed on the substrate can be obtained. Examples of the rinsing solution include distilled water, methanol, ethanol and isopropanol, which may be used alone or in a combination.

Finally, a heating step is carried out for heating the thus-obtained polycondensate relief pattern. The heating temperature is preferably 150 to 400˚C, whereby the photosensitive diazonaphthoquinone compound and the diluent solvent are volatized to obtain the cured relief pattern. In a generally-used method for forming a cured relief pattern using a polyimide or a polybenzoxazole precursor composition, it is necessary to heat to 300 to 400˚C to make the cyclodehydration reaction progress for converting to the polyimide or polybenzoxazole. However, because this is unnecessary in the present method, the present method can be preferably used even for semiconductor devices or the like which are easily affected by heat. Obviously, the present method can also be used in heat treatments to 300 to 400˚C. Examples of such a heat treatment apparatus include a hot plate, an oven or a temperature-programmable heating oven. Air or an inert gas such as nitrogen or argon may be used as the ambient atmosphere during the heat treatment. Further, in cases which require the heat treatment to be carried out at a lower temperature, the heating may be carried out under reduced pressure by utilizing a vacuum pump or the like.

A semiconductor device can be fabricated by using the above-described method for forming a cured relief pattern together with a method known in the art for fabricating a semiconductor device as the method for forming the buffer coating and interlayer insulation film of the semiconductor device. The present method can be especially preferably used for fabricating semiconductor devices which cannot be heat treated at 250˚C or more.

[Examples]

Examples of the embodiments according to the present invention will now be described in more detail with the following Reference Examples, Examples and Comparative Examples.

(Production of polymer solutions)

<Reference Example 1>

A four-necked, separable, glass flask provided with a stainless steel anchor stirrer was equipped with a Dean-Stark trap and a nitrogen inlet tube. The flask was heated by dipping in a silicon oil bath under stirring while passing nitrogen gas therethrough.

Charged together were 26.66 g (60 mmol) of 2,2-bis(3,4-dicarboxyphenyl)hexafluoropropane dianhydride (hereinafter referred to as "6FDA"), 10.8 g (50 mmol) of 3,3'-dihydroxy-4,4'-diaminobiphenyl (hereinafter referred to as "HO-AB"), 0.6 g (6 mmol) of γ-valerolactone, 1.8 g (18 mmol) of pyridine, 150 g of N-methylpyrrolidone (hereinafter referred to as "NMP") and 30 g of toluene, and the resultant mixture was heated at a silicon oil bath temperature of 180˚C while passing nitrogen gas therethrough under stirring at 180 rpm for 1 hour and 40 minutes. During the reaction, distillate of toluene and water (toluene 25 g, water 3 g) was removed. An aliquot of this solution was diluted with NMP, and the molecular weight of the polycondensate was measured using gel permeation chromatography (TSK gel SuperH-RC, TSK gel SuperHM-M manufactured by Tosoh Corporation, developing solvent: NMP 40˚C). The polycondensate had a weight average molecular weight of 25,000 based on polystyrene standards, with a single sharp distribution curve, showing a single composition. This reaction solution was added dropwise to 5 L of water under high-speed stirring, whereby the polymer dispersed and precipitated. The product was recovered and then suitably washed with water. The water was removed, then the product was dried in a vacuum and the polycondensate was recovered (hereinafter sometimes simply referred to as "polymer"). This polymer was charged with NMP to prepare a polymer solution having a resin concentration of 30% by weight (P-1).

<Reference Example 2>

A four-necked flask equipped with a stirring rod, a Dean-Stark trap and a nitrogen inlet tube was charged with 14.89 g (60 mmol) of bicyclo(2,2,2)-oct-7-ene-2,3,5,6-tetracarboxylic dianhydride (manufactured by Aldrich, molecular weight of 248.19, hereinafter referred to as "BCD") and 8.41 g (30 mmol) of (3-amino-4-hydroxyphenyl)sulfone (manufactured by Konishi Chemical Ind. Co., Ltd., molecular weight of 280.3, hereinafter referred to as "SO2-HOAB"). The system was charged with 0.9 g of γ-valerolactone and 1.44 g of pyridine as the catalyst, and 50 g of GBL and 30 g of toluene as the solvent. First, the mixture was stirred at 100 rpm for 20 minutes under a nitrogen atmosphere at room temperature, and then heating was started by dipping in a 180˚C oil bath. The entire solution was stirred at 180 rpm.

During the reaction, water produced as a byproduct was eliminated by azeotropic distillation with toluene, and the water which accumulated at the bottom of the reflux tube was drained off every 30 minutes. One hour after the heating started, the oil bath was removed to stop the heating. Stirring was continued at 180 rpm. After stirring for 30 minutes at room temperature, a two-stage charging was started. The system was charged with 6.01 g (30 mmol) of 3,4'-diaminodiphenyl ether (manufactured by Wakayama Seika Kogyo Co., Ltd., molecular weight of 200.00, hereinafter referred to as "m-ODA"), 6.01 g (30 mmol) of 4,4'-diaminodiphenyl ether (manufactured by Wakayama Seika Kogyo Co., Ltd., molecular weight of 200.00, hereinafter referred to as "p-ODA"), 8.83 g (30 mmol) of 3,3',4,4'-biphenyltetracarboxylic dianhydride (manufactured by Ube Industries, Ltd., molecular weight of 294.33, hereinafter "BPDA") and 2.98 g (12 mmol) of BCD. The system was further charged with 72 g of GBL and 30 g of toluene. The mixture was stirred at 180 rpm for 30 minutes at room temperature, and then heating was again started by dipping in a 180˚C oil bath. During the reaction, the distillate of the reaction byproducts water and toluene was removed. After heating under stirring at 180 rpm for 3 hours at 180˚C, the oil bath was removed to stop the heating. The thus-produced polymer had a weight average molecular weight in terms of polystyrene of 21,500. This reaction solution was added dropwise to 5 L of water under high-speed stirring, whereby the polymer dispersed and precipitated. The product was recovered and then suitably washed with water. The water was removed, then the product was dried in a vacuum and the polymer was recovered. The polymer was charged with GBL to prepare a polymer solution having a resin concentration of 30% by weight (P-2).

<Reference Example 3>

A polymer solution was produced using the same procedures as in Reference Example 2.

A four-necked flask equipped with a stirring rod, a Dean-Stark trap and a nitrogen inlet tube was charged with 14.89 g (60 mmol) of BCD and 8.41 g (30 mmol) of SO2-HOAB. The system was further charged with 0.9 g of γ-valerolactone and 1.44 g of pyridine as the catalyst, and 50 g of GBL and 30 g of toluene as the solvent. Then, the mixture was stirred at 100 rpm for 20 minutes under a nitrogen atmosphere at room temperature, and then heating was started by dipping in a 180˚C oil bath. The entire solution was stirred at 180 rpm. During the reaction, water produced as a byproduct was eliminated by azeotropic distillation with toluene, and the water which accumulated at the bottom of the reflux tube was drained off every 30 minutes. One hour after the heating started, the oil bath was removed to stop the heating. Stirring was continued at 180 rpm. After stirring for 30 minutes at room temperature, a two-stage charging was started. The system was charged with 6.01 g (30 mmol) of m-ODA, 6.01 g (30 mmol) of p-ODA, 8.83 g (30 mmol) of BPDA and 5.96 g (24 mmol) of BCD. The system was further charged with 72 g of GBL and 30 g of toluene. The mixture was stirred at 180 rpm for 30 minutes at room temperature, and then heating was again started by dipping in a 180˚C oil bath. During the reaction, the distillate of the reaction byproducts water and toluene was removed. After heating under stirring at 180 rpm for 3 hours at 180˚C, the oil bath was removed to stop the heating. The thus-produced polymer had a weight average molecular weight in terms of polystyrene of 9,800. This reaction solution was added dropwise to 5 L of water under high-speed stirring, whereby the polymer dispersed and precipitated. The product was recovered and then suitably washed with water. The water was removed, then the product was dried in a vacuum and the polymer was recovered. The polymer was charged with GBL to prepare a polymer solution having a resin concentration of 35% by weight (P-3).

<Reference Example 4>

A polymer solution was produced using the same procedures as in Reference Example 2.

A four-necked flask equipped with a stirring rod, a Dean-Stark trap and a nitrogen inlet tube was charged with 17.37 g (70 mmol) of BCD, 6.41 g (30 mmol) of S02-HOAB, 0.9 g (9 mmol) of γ-valerolactone, 1.2 g (15 mmol) of pyridine, 78 g of N-methylpyrrolidone and 20 g of toluene. The mixture was heated at a silicon oil bath temperature of 180˚C under stirring at 180 rpm for 60 minutes. During the reaction, distillate of toluene and water was removed. The mixture was stirred at 180 rpm for 30 minutes at room temperature, and then charged with 8.83 g (30 mmol) of BPDA, 12.98 g (30 mmol) of 4,4'-di(3-aminophenoxy)phenylsulfone (hereinafter referred to as "BAPS"), 6.01 g (30 mmol) of p-ODA, 100 g of GBL and 20 g of toluene. The mixture was stirred for 1 hour at room temperature, and then heated under stirring at 180 rpm for 3 hours at 180˚C. The reflux liquid was removed. The thus-produced polymer had a weight average molecular weight in terms of polystyrene of 22,700. This reaction solution was added dropwise to 5 L of water under high-speed stirring, whereby the polymer dispersed and precipitated. The product was recovered and then suitably washed with water. The water was removed, then the product was dried in a vacuum and the polymer was recovered. The polymer was charged with GBL to prepare a polymer solution having a resin concentration of 30% by weight (P-4).

<Reference Example 5>

A polymer solution was produced using the same procedures as in Reference Example 1.

A four-necked flask equipped with a stirring rod, a Dean-Stark trap and a nitrogen inlet tube was charged with 26.66 g (60 mmol) of 6FDA, 20.14 g (55 mmol) of 2,2-bis(3-amino-4-hydroxyphenyl)hexafluoropropane (hereinafter, "6FAP"), 0.6 g (6 mmol) of γ-valerolactone, 1.8 g (18 mmol) of pyridine, 150 g of NMP and 30 g of toluene. The mixture was heated at a silicon oil bath temperature of 180˚C while passing nitrogen gas therethrough under stirring at 180 rpm for 1 hour and 40 minutes. During the reaction, distillate of toluene and water was removed. The thus-produced polymer had a weight average molecular weight in terms of polystyrene of 24,600. This reaction solution was added dropwise to 5 L of water under high-speed stirring, whereby the polymer dispersed and precipitated. The product was recovered and then suitably washed with water. The water was removed, then the product was dried in a vacuum and the polymer was recovered. The polymer was charged with GBL to prepare a polymer solution having a resin concentration of 30% by weight (P-5).

<Reference Example 6>

A polymer solution was produced using the same procedures as in Reference Example 2.

A four-necked flask equipped with a stirring rod, a Dean-Stark trap and a nitrogen inlet tube was charged with 22.34 g (90 mmol) of BCD, 25.64 g (70 mmol) of 6FAP, 0.9 g (9 mmol) of γ-valerolactone, 1.5 g (18 mmol) of pyridine, 150 g of GBL and 50 g of toluene. The mixture was stirred at 100 rpm for 20 minutes under a nitrogen atmosphere at room temperature, and then heating was started by dipping in a 180˚C oil bath. The entire solution was stirred at 180 rpm. During the reaction, water produced as a byproduct was eliminated by azeotropic distillation with toluene, and the water which accumulated at the bottom of the reflux tube was drained off every 30 minutes. One hour after the heating started, the oil bath was removed to stop the heating. Stirring was continued at 180 rpm. After stirring for 30 minutes at room temperature, a two-stage charging was started. The system was charged with 2.00 g (10 mmol) of m-ODA, 2.01 g (10 mmol) of p-ODA, 2.94 g (10 mmol) of BPDA and 2.48 g (10 mmol) of BCD. The system was further charged with 30 g of GBL and 10 g of toluene. The mixture was stirred at 180 rpm for 30 minutes at room temperature, and then heating was again started by dipping in a 180˚C oil bath. During the reaction, the distillate of the reaction byproducts water and toluene was removed. After heating under stirring at 180 rpm for 3 hours at 180˚C, the oil bath was removed to stop the heating. The thus-produced polymer had a weight average molecular weight in terms of polystyrene of 10,700. This reaction solution was added dropwise to 5 L of water under high-speed stirring, whereby the polymer dispersed and precipitated. The product was recovered and then suitably washed with water. The water was removed, then the product was dried in a vacuum and the polymer was recovered. The polymer was charged with GBL to prepare a polymer solution having a resin concentration of 35% by weight (P-6).

<Reference Example 7>

A polymer solution was produced using the same procedures as in Reference Example 2. However, in this reference example, as well as in the following Reference Examples 8 to 12, 14 and 15, γ-valerolactone and pyridine were not used as the catalyst. As a result, the ends of the polymer had an acid anhydride structure.

A four-necked flask equipped with a stirring rod, a Dean-Stark trap and a nitrogen inlet tube was charged with 14.89 g (60 mmol) of BCD and 6.01 g (30 mmol) of p-ODA. The system was further charged with 95.5 g of GBL and 30 g of toluene as the solvent. The mixture was stirred at 100 rpm for 20 minutes under a nitrogen atmosphere at room temperature, and then heating was started by dipping in a 180˚C oil bath. The entire solution was stirred at 180 rpm. During the reaction, water produced as a byproduct was eliminated by azeotropic distillation with toluene, and the water which accumulated at the bottom of the reflux tube was drained off every 30 minutes. Two hours after the heating started, a two-stage charging was started. The system was charged with 16.82 g (60 mmol) of SO2-HOAB, and the resulting mixture was stirred for 1 hour. Next, the system was charged with 15.34 g (49.5 mmol) of bis(3,4-dicarboxyphenyl) ether dianhydride (hereinafter referred to as "ODPA"). After heating under stirring at 180 rpm for 3 hours at 180˚C, the oil bath was removed to stop the heating. During the reaction, the distillate of the reaction byproducts water and toluene was removed. The thus-produced polymer had a weight average molecular weight in terms of polystyrene of 12,000. A polymer solution having a resin concentration of 35% by weight (P-7) was thus obtained.

<Reference Example 8>

A polymer solution was produced using the same procedures as in Reference Example 2.

A four-necked flask equipped with a stirring rod, a Dean-Stark trap and a nitrogen inlet tube was charged with 14.89 g (60 mmol) of BCD and 6.01 g (30 mmol) of m-ODA. The system was further charged with 95.5 g of GBL and 30 g of toluene as the solvent. The mixture was stirred at 100 rpm for 20 minutes under a nitrogen atmosphere at room temperature, and then heating was started by dipping in a 180˚C oil bath. The entire solution was stirred at 180 rpm. During the reaction, water produced as a byproduct was eliminated by azeotropic distillation with toluene, and the water

which accumulated at the bottom of the reflux tube was drained off every 30 minutes. Two hours after the heating started, a two-stage charging was started. The system was charged with 16.82 g (60 mmol) of S02-HOAB, and the resulting mixture was stirred for 1 hour. Next, the system was charged with 15.34 g (49.5 mmol) of ODPA. After heating under stirring at 180 rpm for 3 hours at 180˚C, the oil bath was removed to stop the heating. During the reaction, the distillate of the reaction byproducts water and toluene was removed. The thus-produced polymer had a weight average molecular weight in terms of polystyrene of 12,000. A polymer solution having a resin concentration of 35% by weight (P-8) was thus obtained.

<Reference Example 9>

A polymer solution was produced using the same procedures as in Reference Example 2.

A four-necked flask equipped with a stirring rod, a Dean-Stark trap and a nitrogen inlet tube was charged with 14.89 g (60 mmol) of BCD and 6.01 g (30 mmol) of p-ODA. The system was further charged with 103.1 g of GBL and 30 g of toluene as the solvent. The mixture was stirred at 100 rpm for 20 minutes under a nitrogen atmosphere at room temperature, and then heating was started by dipping in a 180˚C oil bath. The entire solution was stirred at 180 rpm. During the reaction, water produced as a byproduct was eliminated by azeotropic distillation with toluene, and the water which accumulated at the bottom of the reflux tube was drained off every 30 minutes. Two hours after the heating started, a two-stage charging was started. The system was charged with 16.82 g (60 mmol) of S02-HOAB, and the resulting mixture was stirred for 1 hour. Next, the system was charged with 19.32 g (43.5 mmol) of 6FDA. After heating under stirring at 180 rpm for 3 hours at 180˚C, the oil bath was removed to stop the heating. During the reaction, the distillate of the reaction byproducts water and toluene was removed. The thus-produced polymer had a weight average molecular weight in terms of polystyrene of 17,000. A polymer solution having a resin concentration of 35% by weight (P-9) was thus obtained.

<Reference Example 10>

A polymer solution was produced using the same procedures as in Reference Example 2.

A four-necked flask equipped with a stirring rod, a Dean-Stark trap and a nitrogen inlet tube was charged with 18.61 g (60 mmol) of ODPA and 12.97 g (30 mmol) of 4,4'-di(3-aminophenoxy)phenylsulfone (hereinafter referred to as "BAPS"). The system was further charged with 109.7 g of NMP and 30 g of toluene as the solvent. The mixture was stirred at 100 rpm for 20 minutes under a nitrogen atmosphere at room temperature, and then heating was started by dipping in a 180˚C oil bath. The entire solution was stirred at 180 rpm. During the reaction, water produced as a byproduct was eliminated by azeotropic distillation with toluene, and the water which accumulated at the bottom of the reflux tube was drained off every 30 minutes. Two hours after the heating started, a two-stage charging was started. The system was charged with 16.82 g (60 mmol) of S02-HOAB, and the resulting mixture was stirred for 1 hour. Next, the system was charged with 12.29 g (49.5 mmol) of BCD. After heating under stirring at 180 rpm for 3 hours at 180˚C, the oil bath was removed to stop the heating. During the reaction, the distillate of the reaction byproducts water and toluene was removed. The thus-produced polymer had a weight average molecular weight in terms of polystyrene of 11,000. A polymer solution having a resin concentration of 35% by weight (P-10) was thus obtained.

<Reference Example 11>

A polymer solution was produced using the same procedures as in Reference Example 2.

A four-necked flask equipped with a stirring rod, a Dean-Stark trap and a nitrogen inlet tube was charged with 26.65 g (60 mmol) of 6FDA and 6.01 g (30 mmol) of p-ODA. The system was further charged with 109.7 g of GBL and 30 g of toluene as the solvent. The mixture was stirred at 100 rpm for 20 minutes under a nitrogen atmosphere at room temperature, and then heating was started by dipping in a 180˚C oil bath. The entire solution was stirred at 180 rpm. During the reaction, water produced as a byproduct was eliminated by azeotropic distillation with toluene, and the water which accumulated at the bottom of the reflux tube was drained off every 30 minutes. Two hours after the heating started, a two-stage charging was started. The system was charged with 10.99 g (30 mmol) of 6FAP, and the resulting mixture was stirred for 1 hour. Next, the system was charged with 13.49 g (43.5 mmol) of ODPA. After heating under stirring at 180 rpm for 3 hours at 180˚C, the oil bath was removed to stop the heating. During the reaction, the distillate of the reaction byproducts water and toluene was removed. The thus-produced polymer had a weight average molecular weight in terms of polystyrene of 11,000. A polymer solution having a resin concentration of 35% by weight (P-11) was thus obtained.

<Reference Example 12>

A polymer solution was produced using the same procedures as in Reference Example 2.

A four-necked flask equipped with a stirring rod, a Dean-Stark trap having balls and a nitrogen inlet tube was charged with 11.76 g (60 mmol) of cyclobutane tetracarboxylic dianhydride, 16.50 g (45 mmol) of 6FAP and 4.33 g (10 mmol) of BAPS. The system was further charged with 100 g of GBL and 20 g of toluene. The mixture was stirred for 1 hour at room temperature, and then heated under stirring at 180 rpm for 3 hours at 180˚C. The reflux liquid was removed. The thus-produced polymer had a weight average molecular weight in terms of polystyrene of 20,300. This reaction solution was added dropwise to 5 L of water under high-speed stirring, whereby the polymer dispersed and precipitated. The product was recovered and then suitably washed with water. The water was removed, then the product was dried in a vacuum and the polymer was recovered. The polymer was charged with GBL to prepare a polymer solution having a resin concentration of 30% by weight (P-12).

<Reference Example 13>

A polymer solution was produced using the same procedures as in Reference Example 2.

A four-necked flask equipped with a stirring rod, a Dean-Stark trap and a nitrogen inlet tube was charged with 24.82 g (100 mmol) of BCD, 26.91 g (96 mmol) of S02-HOAB and, as the catalyst, 1.0 g (10 mmol) of γ-valerolactone and 2.4 g (30 mmol) of pyridine and, as the solvent, 171 g of γ-butyrolactone (hereinafter referred to as "GBL") and 30 g of toluene. The mixture was heated at a silicon oil bath temperature of 180˚C under stirring at 180 rpm for 65 minutes, and then at 100 rpm for 35 minutes. During the reaction, distillate of toluene and water was removed. The thus-produced polymer had a weight average molecular weight in terms of polystyrene of 74,000. This reaction solution was added dropwise to 5 L of water under high-speed stirring, whereby the polymer dispersed and precipitated. The product was recovered and then suitably washed with water. The water was removed, then the product was dried in a vacuum and the polymer was recovered. The polymer was charged with GBL to prepare a polymer solution having a resin concentration of 25% by weight (P-13).

<Reference Example 14>

A polymer solution was produced using the same procedures as in Reference Example 2.

A four-necked flask equipped with a stirring rod, a Dean-Stark trap having balls and a nitrogen inlet tube was charged with 21.98 g (60 mmol) of 6FAP and 9.94 g (30 mmol) of 4,4-diaminodiphenylsulfone, 196 g of NMP and 40 g of toluene, and the mixture was stirred at room temperature. The mixture was then charged with 35.82 g (100 mmol) of 3,3,4,4-biphenylsulfone tetracarboxylic dianhydride, and the mixture was stirred for 2 hours at room temperature. Then, the mixture was heated under stirring at 180 rpm for 3 hours at 180˚C. During the reaction, water produced as a byproduct was eliminated by azeotropic distillation with toluene, and the water which accumulated at the bottom of the reflux tube was drained off every 30 minutes. The thus-produced polyimide polymer had a weight average molecular weight in terms of polystyrene of 26,800. This reaction solution was added dropwise to 5 L of water under high-speed stirring, whereby the polymer dispersed and precipitated. The product was recovered and then suitably washed with water. The water was removed, then the product was dried in a vacuum and the polymer was recovered. The polymer was charged with GBL to prepare a polymer solution having a resin concentration of 30% by weight (P-14).

<Reference Example 15>

A polymer solution was produced using the same procedures as in Reference Example 2.

A four-necked flask equipped with a stirring rod, a Dean-Stark trap having balls and a nitrogen inlet tube was charged with 14.02 g (50 mmol) of S02-HOAB, 12.42 g (50 mmol) of 4,4-diaminodiphenylsulfone, 164 g of NMP and 40 g of toluene. The mixture was then charged with 27.92 g (90 mmol) of 3,3,4,4-biphenylsulfone tetracarboxylic dianhydride, and the mixture was stirred for 2 hours at room temperature. Then, the mixture was heated under stirring at 180 rpm for 3 hours at 180˚C. The reflux liquid was removed. The thus-produced polymer had a weight average molecular weight in terms of polystyrene of 29,200. This reaction solution was added dropwise to 5 L of water under high-speed stirring, whereby the polymer dispersed and precipitated. The product was recovered and then suitably washed with water. The water was removed, then the product was dried in a vacuum and the polymer was recovered. The polymer was charged with GBL to prepare a polymer solution having a resin concentration of 30% by weight (P-15).

<Reference Example 16>

In a separable flask having a capacity of 2 L, 183.2 g (0.50 mol) of 6FAP, 71.2 g (0.9 mol) of pyridine and 692

g of dimethylacetamide (hereinafter referred to as "DMAc") were mixed and stirred at room temperature (25˚C) to dissolve the diamine.

Next, the mixture was cooled to 8˚C with a water bath. To this mixture was then added dropwise a separate solution of 135.8 g (0.46 mol) of 4,4'-diphenyl ether dicarboxylate dichloride dissolved in 398 g of diethylene glycol dimethyl ether (hereinafter referred to as "DMDG") with a dropping funnel. The time require for the dropping was 80 minutes. The maximum reaction temperature was 12˚C.

Three hours after the dropping finished, the above-described reaction solution was added dropwise to 12 L of water under high-speed stirring, whereby the polymer dispersed and precipitated. The product was recovered and then suitably washed with water. The water was removed, then the product was dried in a vacuum to obtain a hydroxypolyamide. The thus-synthesized hydroxypolyamide had a weight average molecular weight in terms of polystyrene of 23,700. The polymer was charged with GBL to prepare a polymer solution having a resin concentration of 30% by weight (P-16).

(13C-NMR Measurement)

The 13C-NMR of the polymer solutions (P-6 to P-11) synthesized in Reference Examples 5 and 7 to 11 was measured, and these results are shown in Figs. 1 to 6. The 13C-NMR measurement conditions are as follows. Apparatus: Avance 600 Spectrometer manufactured by Bruker Biospin
Solvent: The polymer solution serving as the sample was dissolved in a 1:1 ratio with gamma-butyrolactone NMR Test tube:Double tube (inner tube: DMSO-d6 as a lock solvent; outer tube: sample solution)
Measuring method:Complete proton decoupling method
Total number: 3,000 times
Measuring temperature:Room temperature (about 25˚C)

(Production of photosensitive naphthoquinonediazide compounds)

<Reference Example 17>

In a 1L, separable flask equipped with a stirrer, a dropping funnel and a thermometer, 30 g of a compound of 3,3'-bis(2-hydroxy-5-methylbenzyl)-4,4'-dihydroxy-2,2',5,5'-tetramethyldiphenylmethane (manufactured by Asahi Organic Chemicals Industry Co., Ltd., product name: BIPC-BI25X-F) as a polyhydroxy compound and an amount equivalent to 50 mol% of the OH groups thereof of 1,2-naphthoquinonediazide-4-sulfonate chloride were dissolved in 300 g of acetone under stirring. The flask was then adjusted to a temperature of 30˚C using a thermostatic bath. Next, 12 g of triethylamine was dissolved in 12 g of acetone, and this mixture was charged into a dropping funnel. The mixture was then added dropwise over 30 minutes into the flask. After the dropping was finished, this mixture was stirred for another 30 minutes. Hydrochloric acid was then added dropwise, and the mixture was stirred for a further 30 minutes to terminate the reaction. The mixture was then filtrated to remove the triethylamine hydrochloride. Then, the obtained filtrate was added dropwise to a 3 L beaker while stirring and mixing with 1,640 g of pure water and 22 g of hydrochloric acid to obtain a precipitate. This precipitate was washed with water and filtrated, and then the resultant product was dried under reduced pressure at 40˚C for 48 hours to obtain the photosensitive diazonaphthoquinone compound (B) (PAC-1).

<Reference Example 18>

In a 1L, separable flask equipped with a stirrer, a dropping funnel and a thermometer, 30 g (0.0565 mol) of a compound of the following compound (manufactured by Asahi Organic Chemicals Industry Co., Ltd., product name: BIPC-BI25X-TPA) as a polyhydroxy compound and 48.6 g (0.181 mol) of 1,2-naphthoquinonediazide-4-sulfonate chloride, which is an amount equivalent to 80 mol% of the OH groups thereof, were dissolved in 300 g of acetone under stirring. The flask was then adjusted to a temperature of 30˚C using a thermostatic bath. Next, 18.3 g of triethylamine was dissolved in 18 g of acetone, and this mixture was charged into a dropping funnel. The mixture was then added dropwise over 30 minutes into the flask. After the dropping was finished, this mixture was stirred for another 30 minutes. Hydrochloric acid was then added dropwise, and the mixture was stirred for a further 30 minutes to terminate the reaction. The mixture was then filtrated to remove the triethylamine hydrochloride. Then, the obtained filtrate was added dropwise to a 3 L beaker while stirring and mixing with 1,640 g of pure water and 22 g of hydrochloric acid to obtain a precipitate. This precipitate was washed with water and filtrated, and then the resultant product was dried under reduced pressure at 40˚C for 48 hours to obtain the photosensitive diazonaphthoquinone compound (B) (PAC-2).

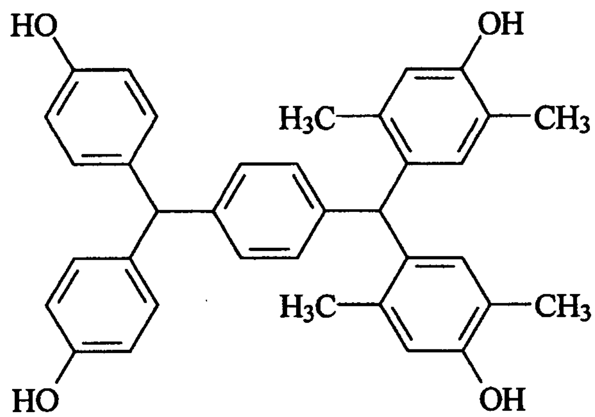

<Reference Example 19>

In a 1L, separable flask equipped with a stirrer, a dropping funnel and a thermometer, 30 g (0.0474 mol) of a compound of the following compound (manufactured by Honshu Chemical Industry Co., Ltd., product name: Tekoc-4HBPA) as a polyhydroxy compound and 40.76 g (0.152 mol) of 1,2-naphthoquinonediazide-4-sulfonate chloride, which is an amount equivalent to 80 mol% of the OH groups thereof, were dissolved in 300 g of acetone under stirring. The flask was then adjusted to a temperature of 30˚C using a thermostatic bath. Next, 15.4 g of triethylamine was dissolved in 15 g of acetone, and this mixture was charged into a dropping funnel. The mixture was then added dropwise over 30 minutes into the flask. After the dropping was finished, this mixture was stirred for another 30 minutes. Hydrochloric acid was then added dropwise, and the mixture was stirred for a further 30 minutes to terminate the reaction. The mixture was then filtrated to remove the triethylamine hydrochloride. Then, the obtained filtrate was added dropwise to a 3 L beaker while stirring and mixing with 1,640 g of pure water and 22 g of hydrochloric acid to obtain a precipitate. This precipitate was washed with water and filtrated, and then the resultant product was dried under reduced pressure at 40˚C for 48 hours to obtain the photosensitive diazonaphthoquinone compound (B) (PAC-3).

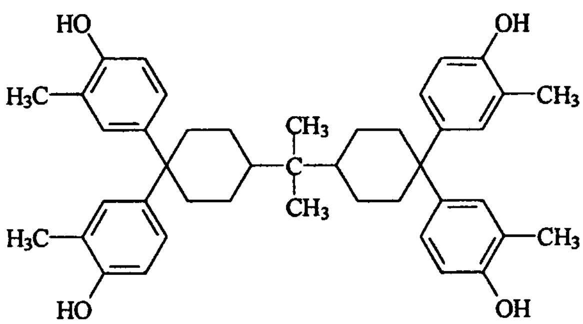

<Reference Example 20>

In a 1L, separable flask equipped with a stirrer, a dropping funnel and a thermometer, 30 g (0.0423 mol) of a compound of 3,3',5,5,'-tetrakis(2-hydroxy-5-methylbenzyl)-4,4'-dihydroxy-diphenylpropane (manufactured by Asahi Organic Chemicals Industry Co., Ltd., product name: TEPC-BIP-A) as a polyhydroxy compound and 36.39 g (0.135 mol) of 1,2-naphthoquinonediazide-4-sulfonate chloride, which is an amount equivalent to 80 mol% of the OH groups thereof, were dissolved in 300 g of acetone under stirring. The flask was then adjusted to a temperature of 30˚C using a thermostatic bath. Next, 13.7 g of triethylamine was dissolved in 14 g of acetone, and this mixture was charged into a dropping funnel. The mixture was then added dropwise over 30 minutes into the flask. After the dropping was finished, this mixture was stirred for another 30 minutes. Hydrochloric acid was then added dropwise, and the mixture was stirred for a further 30

minutes to terminate the reaction. The mixture was then filtrated to remove the triethylamine hydrochloride. Then, the obtained filtrate was added dropwise to a 3 L beaker while stirring and mixing with 1,640 g of pure water and 22 g of hydrochloric acid to obtain a precipitate. This precipitate was washed with water and filtrated, and then the resultant product was dried under reduced pressure at 40˚C for 48 hours to obtain the photosensitive diazonaphthoquinone compound (B) (PAC-4).

<Reference Example 21>

In a 1L, separable flask equipped with a stirrer, a dropping funnel and a thermometer, 30 g (0.0482 mol) of a compound of the following compound (manufactured by Asahi Organic Chemicals Industry Co., Ltd., product name: BIPC-PDAB) as a polyhydroxy compound and 64.75 g (0.241 mol) of 1,2-naphthoquinonediazide-4-sulfonate chloride, which is an amount equivalent to 62.5 mol% of the OH groups thereof, were dissolved in 300 g of acetone under stirring. The flask was then adjusted to a temperature of 30˚C using a thermostatic bath. Next, 24.4 g of triethylamine was dissolved in 24 g of acetone, and this mixture was charged into a dropping funnel. The mixture was then added dropwise over 30 minutes into the flask. After the dropping was finished, this mixture was stirred for another 30 minutes. Hydrochloric acid was then added dropwise, and the mixture was stirred for a further 30 minutes to terminate the reaction. The mixture was then filtrated to remove the triethylamine hydrochloride. Then, the obtained filtrate was added dropwise to a 3 L beaker while stirring and mixing with 1,640 g of pure water and 30 g of hydrochloric acid to obtain a precipitate. This precipitate was washed with water and filtrated, and then the resultant product was dried under reduced pressure at 40˚C for 48 hours to obtain the photosensitive diazonaphthoquinone compound (B) (PAC-5) .

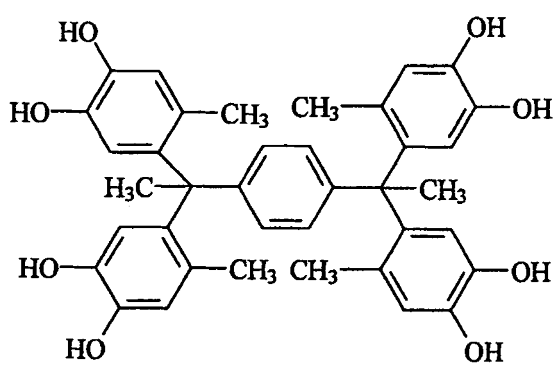

<Reference Example 22>

Dissolved into 920 mL of ethanol were 102.4 g (0.92 mol) of resorcinol and 92.0 g (0.92 mol) of hexanol. The resultant solution was cooled to 0˚C, and then 148 mL of 12 N hydrochloric acid was added dropwise thereto under stirring. This mixture was then stirred for 10 hours at 70˚C under a nitrogen atmosphere. The temperature was returned to room temperature, and then the mixture was filtrated. The precipitate was removed. The filtrate was washed with 80˚C water, then dried. The obtained solid was recrystallized using a mixed solvent of methanol, hexane and acetone. The resultant product was dried under vacuum to obtain the following resorcinol ring tetramer at a 50% yield.

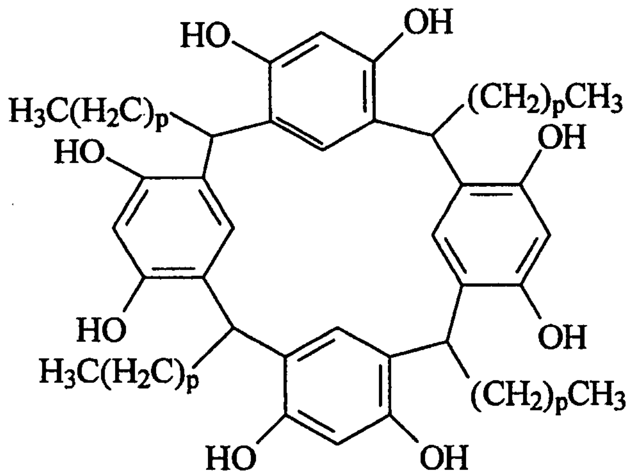

(wherein p is 4)

Next, 76.9 g (0.1 mol) of the thus-synthesized resorcinol ring tetramer, 134.3 g (0.5 mol, esterification rate of the naphthoquinonediazide sulfonic acid equivalent to 62.5%) of 1,2-naphthoquinonediazide-4-sulfonate chloride and 1,057 g of tetrahydrofuran were charged together and dissolved under stirring at 20˚C. Then, a solution of 53.14 g (0.525 mol) of triethylamine diluted with 266 g of tetrahydrofuran was added dropwise to the mixture at a constant rate over 30 minutes. During the dropping, the temperature of the reaction solution was controlled in a range of 20 to 30˚C using an ice water bath. After the dropping was finished, the solution was stirred for a further 30 minutes at 20˚C, then left to stand. The solution was then charged in one go with 6.83 g of aqueous hydrochloric acid having a concentration of 36% by mass. The reaction solution was then cooled using an ice water bath. Precipitated solid matter was separated by suction filtration. The filtrate obtained at this stage was added dropwise over 1 hour under stirring to 10 L of aqueous hydrochloric acid having a concentration of 0.5% by mass to precipitate the desired compound, which was then recovered by suction filtration. The obtained cake-like recovered product was again dispersed in 5 L of deionized water, the resultant solution was stirred and washed, and then the product was recovered by filtration. This water-washing operation was repeated three times. The ultimately-obtained cake-like product was dried under vacuum for 48 hours at 40˚C to obtain the photosensitive diazonaphthoquinone compound (B) (PAC-6).

<Reference Eample 23>

A separable flask having a volume of 1 L was charged with 109.9 g (0.3 mol) of 2,2-bis(3-amino-4-hydroxyphenyl)-hexafluoropropane, 330 g of tetrahydrofuran (THF) and 47.5 g (0.6 mol) of pyridine. The resultant mixture was charged at room temperature with 98.5 g (0.6 mol) of 5-norbornene-2,3-dicarboxylate anhydride as a powder. The mixture was reacted as is under stirring at room temperature for 3 days. Then, upon confirmation of the reaction by high performance liquid chromatography (HPLC), none of the raw materials were detected, and the formed product was detected at a purity of 99% as a single peak. This reaction solution was added dropwise as is under stirring to 1 L of deionized water, whereby the formed product was precipitated.

Next, the precipitate was separated by filtration, and the resultant product was charged with 500 mL of THF to dissolve under stirring. This uniform solution was passed through a glass column filled with 100 g of the cation-exchange resin Amberlist 15 (manufactured by Organo Corporation) to remove residual pyridine. The solution was then added dropwise under high-speed stirring to 3 L of deionized water, whereby the formed product was precipitated. The product was separated by filtration and then dried under vacuum to obtain an imidophenol compound (NI) having the following structure at a yield of 86%.

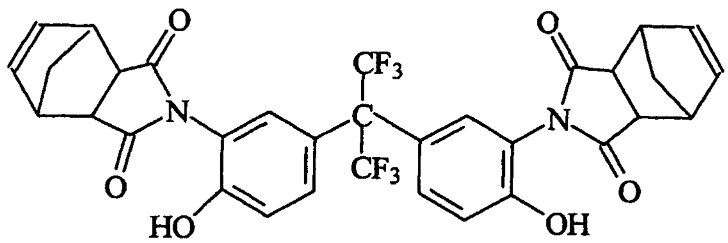

The imidization of the formed product was confirmed by the facts that the characteristic absorbance of amide groups of 1,394 and 1,774 $cm^{-1}$ appeared on the IR chart, the absence of the characteristic absorbance of amide groups in the vicinity of 1,540 or 1,650 $cm^{-1}$, and that the absence of a proton peak of the amide and carboxylic acid on the NMR chart. Next, 65.9 g (0.1 mol) of the above-described imidophenol compound (NI), 53.7 g (0.2 mol) of 1,2-naphthoquinonediazide-4-sulfonate chloride and 560 g of acetone were charged together, and the resultant mixture was dissolved under stirring at 20˚C. Then, a solution of 21.2 g (0.21 mol) of triethylamine diluted with 106.2 g of acetone was added dropwise to the mixture at a constant rate over 30 minutes. During the dropping, the temperature of the reaction solution was controlled in a range of 20 to 30˚C using an ice water bath or the like.

After the dropping was finished, the solution was stirred for a further 30 minutes at 20˚C, then left to stand. The solution was then charged in one go with 5.6 g of aqueous hydrochloric acid having a concentration of 36% by weight. The reaction solution was then cooled using an ice water bath. Precipitated solid matter was separated by suction filtration. The filtrate obtained at this stage was added dropwise over 1 hour under stirring to 5 L of aqueous hydrochloric acid having a concentration of 0.5% by weight to precipitate the desired compound, which was then recovered by suction filtration. The obtained cake-like recovered product was again dispersed in 5 L of deionized water, the resultant solution was stirred and washed, and then the product was recovered by filtration. This water-washing operation was repeated three times. The ultimately-obtained cake-like product was dried under vacuum for 48 hours at 40˚C to obtain the photosensitive diazonaphthoquinone compound (B) (PAC-7).

<Reference Example 24>

In a 1L, separable flask equipped with a stirrer, a dropping funnel and a thermometer, 30 g (0.0707 mol) of a compound of 4,4'-(1-(2-(4-hydroxyphenyl)-2-propyl)phenyl)ethylidene)bisphenol (manufactured by Honshu Chemical Industry Co., Ltd., product name: Tris-PA) as a polyhydroxy compound and 47.49 g (0.177 mol) of 1,2-naphthoquinonediazide-4-sulfonate chloride, which is an amount equivalent to 83.3 mol% of the OH groups thereof, were dissolved in 300 g of acetone under stirring. The flask was then adjusted to a temperature of 30˚C using a thermostatic bath. Next, 17.9 g of triethylamine was dissolved in 18 g of acetone, and this mixture was charged into a dropping funnel. The mixture was then added dropwise over 30 minutes into the flask. After the dropping was finished, this mixture was stirred for another 30 minutes. Hydrochloric acid was then added dropwise, and the mixture was stirred for a further 30 minutes to terminate the reaction. The mixture was then filtrated to remove the triethylamine hydrochloride. Then, the obtained filtrate was added dropwise to a 3 L beaker while stirring and mixing with 1,640 g of pure water and 30 g of hydrochloric acid to obtain a precipitate. This precipitate was washed with water and filtrated, and then the resultant product was dried under reduced pressure at 40˚C for 48 hours to obtain the photosensitive diazonaphthoquinone compound (B) (PAC-8).

<Reference Example 25>

In a 1L, separable flask equipped with a stirrer, a dropping funnel and a thermometer, 30 g (0.0269 mol) of a compound of the following compound (manufactured by Honshu Chemical Industry Co., Ltd., product name: TPPAl100-2C) as a polyhydroxy compound and 51.98 g (0.193 mol) of 1,2-naphthoquinonediazide-4-sulfonate chloride, which is an amount equivalent to 80 mol% of the OH groups thereof, were dissolved in 300 g of acetone under stirring. The flask was then adjusted to a temperature of 30˚C using a thermostatic bath. Next, 19.5 g of triethylamine was dissolved in 20 g of acetone, and this mixture was charged into a dropping funnel. The mixture was then added dropwise over 30 minutes into the flask. After the dropping was finished, this mixture was stirred for another 30 minutes. Hydrochloric acid was then added dropwise, and the mixture was stirred for a further 30 minutes to terminate the reaction. The mixture was then filtrated to remove the triethylamine hydrochloride. Then, the obtained filtrate was added dropwise to a 3 L

beaker while stirring and mixing with 1,640 g of pure water and 30 g of hydrochloric acid to obtain a precipitate. This precipitate was washed with water and filtrated, and then the resultant product was dried under reduced pressure at 40˚C for 48 hours to obtain the photosensitive diazonaphthoquinone compound (B) (PAC-9).

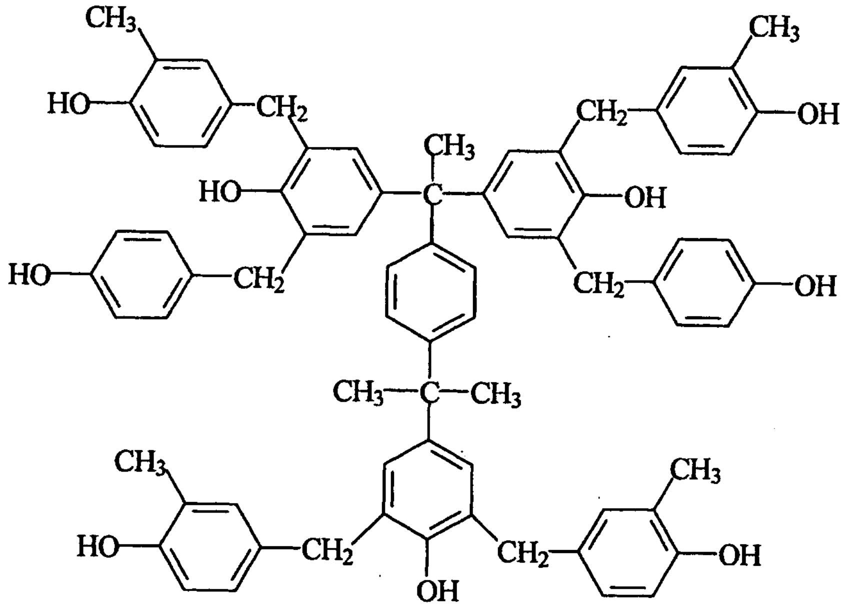

<Reference Example 26>

In a 1L, separable flask equipped with a stirrer, a dropping funnel and a thermometer, 30 g (0.0857 mol) of a compound of 4,6-bis((4-hydroxyphenyl)ethyl)benzene-1,3-diol (manufactured by Honshu Chemical Industry Co., Ltd., product name: BisHPMC-RS) as a polyhydroxy compound and 73.7 g (0.274 mol) of 1,2-naphthoquinonediazide-4-sulfonate chloride, which is an amount equivalent to 80 mol% of the OH groups thereof, were dissolved in 300 g of acetone under stirring. The flask was then adjusted to a temperature of 30˚C using a thermostatic bath. Next, 27.7 g of triethylamine was dissolved in 28 g of acetone, and this mixture was charged into a dropping funnel. The mixture was then added dropwise over 30 minutes into the flask. After the dropping was finished, this mixture was stirred for another 30 minutes. Hydrochloric acid was then added dropwise, and the mixture was stirred for a further 30 minutes to terminate the reaction. The mixture was then filtrated to remove the triethylamine hydrochloride. Then, the obtained filtrate was added dropwise to a 3 L beaker while stirring and mixing with 1,640 g of pure water and 30 g of hydrochloric acid to obtain a precipitate. This precipitate was washed with water and filtrated, and then the resultant product was dried under reduced pressure at 40˚C for 48 hours to obtain the photosensitive diazonaphthoquinone compound (B) (PAC-10).

<Reference Example 27>

In a 1L, separable flask equipped with a stirrer, a dropping funnel and a thermometer, 30 g (0.13 mol) of 2,3,4-trihydroxybenzophenone as a polyhydroxy compound and 69.9 g (0.26 mol) of 1,2-naphthoquinonediazide-4-sulfonate chloride, which is an amount equivalent to 67 mol% of the OH groups thereof, were dissolved in 300 g of acetone under stirring. The flask was then adjusted to a temperature of 30˚C using a thermostatic bath. Next, 26.3 g of triethylamine was dissolved in 26 g of acetone, and this mixture was charged into a dropping funnel. The mixture was then added dropwise over 30 minutes into the flask. After the dropping was finished, this mixture was stirred for another 30 minutes. Hydrochloric acid was then added dropwise, and the mixture was stirred for a further 30 minutes to terminate the reaction. The mixture was then filtrated to remove the triethylamine hydrochloride. Then, the obtained filtrate was added dropwise to a 3 L beaker while stirring and mixing with 1,640 g of pure water and 30 g of hydrochloric acid to obtain a precipitate. This precipitate was washed with water and filtrated, and then the resultant product was dried under reduced pressure at 40˚C for 48 hours to obtain the photosensitizing agent (PAC-11).

<Reference Example 28>

In a 1L, separable flask equipped with a stirrer, a dropping funnel and a thermometer, 30 g (0.13 mol) of 2,3,4-trihydroxybenzophenone as a polyhydroxy compound and 69.9 g (0.26 mol) of 1,2-naphthoquinonediazide-5-sulfonate chloride, which is an amount equivalent to 67 mol% of the OH groups thereof, were dissolved in 300 g of acetone under stirring. The flask was then adjusted to a temperature of 30˚C using a thermostatic bath. Next, 26.3 g of triethylamine was dissolved in 26 g of acetone, and this mixture was charged into a dropping funnel. The mixture was then added dropwise over 30 minutes into the flask. After the dropping was finished, this mixture was stirred for another 30 minutes. Hydrochloric acid was then added dropwise, and the mixture was stirred for a further 30 minutes to terminate the reaction. The mixture was then filtrated to remove the triethylamine hydrochloride. Then, the obtained filtrate was added dropwise to a 3 L beaker while stirring and mixing with 1,640 g of pure water and 30 g of hydrochloric acid to obtain a precipitate. This precipitate was washed with water and filtrated, and then the resultant product was dried under reduced pressure at 40˚C for 48 hours to obtain the photosensitive diazonaphthoquinone compound (B) (PAC-12).

<Reference Example 29>

In a 1L, separable flask equipped with a stirrer, a dropping funnel and a thermometer, 30 g (0.238 mol) of 1,3,5-trihydroxybenzene as a polyhydroxy compound and 115.1 g (0.43 mol) of 1,2-naphthoquinonediazide-4-sulfonate chloride, which is an amount equivalent to 60 mol% of the OH groups thereof, were dissolved in 300 g of acetone under stirring. The flask was then adjusted to a temperature of 30˚C using a thermostatic bath. Next, 43.5 g of triethylamine was dissolved in 43 g of acetone, and this mixture was charged into a dropping funnel. The mixture was then added dropwise over 30 minutes into the flask. After the dropping was finished, this mixture was stirred for another 30 minutes. Hydrochloric acid was then added dropwise, and the mixture was stirred for a further 30 minutes to terminate the reaction. The mixture was then filtrated to remove the triethylamine hydrochloride. Then, the obtained filtrate was added dropwise to a 3 L beaker while stirring and mixing with 1,640 g of pure water and 30 g of hydrochloric acid to obtain a precipitate. This precipitate was washed with water and filtrated, and then the resultant product was dried under reduced pressure at 40˚C for 48 hours to obtain the photosensitive diazonaphthoquinone compound (B) (PAC-13).

<Reference Example 30>

In a 1L, separable flask equipped with a stirrer, a dropping funnel and a thermometer, 30 g (0.277 mol) of 4-methylphenol as a polyhydroxy compound and 74.54 g (0.277 mol) of 1,2-naphthoquinonediazide-4-sulfonate chloride, which is an amount equivalent to 100 mol% of the OH groups thereof, were dissolved in 300 g of acetone under stirring. The flask was then adjusted to a temperature of 30˚C using a thermostatic bath. Next, 28 g of triethylamine was dissolved in 28 g of acetone, and this mixture was charged into a dropping funnel. The mixture was then added dropwise over 30 minutes into the flask. After the dropping was finished, this mixture was stirred for another 30 minutes. Hydrochloric acid was then added dropwise, and the mixture was stirred for a further 30 minutes to terminate the reaction. The mixture was then filtrated to remove the triethylamine hydrochloride. Then, the obtained filtrate was added dropwise to a 3 L beaker while stirring and mixing with 1,640 g of pure water and 30 g of hydrochloric acid to obtain a precipitate. This precipitate was washed with water and filtrated, and then the resultant product was dried under reduced pressure at 40˚C for 48 hours to obtain the photosensitive diazonaphthoquinone compound (B) (PAC-14).

<Reference Example 31>

In a 1L, separable flask equipped with a stirrer, a dropping funnel and a thermometer, 26.99 g (0.092 mol) of tris(4-hydroxyphenyl)methane as a polyhydroxy compound and 74.54 g (0.277 mol) of 1,2-naphthoquinonediazide-5-sulfonate chloride, which is an amount equivalent to 100 mol% of the OH groups thereof, were dissolved in 300 g of acetone under stirring. The flask was then adjusted to a temperature of 30˚C using a thermostatic bath. Next, 28 g of triethylamine was dissolved in 28 g of acetone, and this mixture was charged into a dropping funnel. The mixture was then added dropwise over 30 minutes into the flask. After the dropping was finished, this mixture was stirred for another 30 minutes. Hydrochloric acid was then added dropwise, and the mixture was stirred for a further 30 minutes to terminate the reaction. The mixture was then filtrated to remove the triethylamine hydrochloride. Then, the obtained filtrate was added dropwise to a 3 L beaker while stirring and mixing with 1,640 g of pure water and 30 g of hydrochloric acid to obtain a precipitate. This precipitate was washed with water and filtrated, and then the resultant product was dried under reduced pressure at 40˚C for 48 hours to obtain the photosensitive diazonaphthoquinone compound (B) (PAC-15).

Next, Examples and Comparative Examples of the present invention will be described.

(Preparation of photosensitive resin compositions and formation of cured relief patterns)

<Examples 1 to 21 and Comparative Examples 1 to 20>

Based on 100 parts by mass of pure polymer content, 20 parts by mass of the photosensitive diazonaphthoquinone compound (B) component (PAC-1 to PAC-15) obtained in Reference Examples 17 to 31 was dissolved in the polymer solution (A) component (P-1 to P-16) obtained in Reference Examples 1 to 16 in the combinations shown in the following Table 1. The resultant mixture was then filtrated with a 0.5 μm filter to obtain a photosensitive resin composition.

A solution of 1% by weight 3-aminopropyltriethoxysilane in methanol was coated on a 5-inch silicon wafer. The wafer was subjected to a heat-treatment for 10 minutes at 250°C and an adhesive auxiliary treatment. The above-described photosensitive resin composition was coated on the 5-inch silicon wafer which had been subjected to the adhesive auxiliary treatment by a spin coater (manufactured by Tokyo Electron Ltd., Clean Track Mark 7), and then dried for 270 seconds at 125°C to obtain a 4.5 μm-thick coating. This coating was passed through a reticle using the NSR2005i8A i-Line stepper exposure apparatus (manufactured by Nikon Corporation) to expose the coating while varying the exposure amount in a step-like manner. The silicon wafer was developed while adjusting the developing time to have a post-development coating thickness of 3.83 μm under the conditions of, for Examples 1 to 4 and Comparative Examples 1 to 4, 35°C with an aqueous solution of 40 g of NMP, 40 g of aminoethanol and 40 g of water (hereinafter sometimes referred to as "developing solution A" (refer to Table 1)); for Examples 5 to 10 and 12 to 21 and Comparative Examples 5 to 10 and 12 to 19, 23°C with a solution of 2.38% aqueous tetramethylammonium hydroxide (hereinafter sometimes referred to as "2.38% TMAH" (refer to Table 1), (manufactured by Clariant Japan, AZ300MIF)); and for Example 11 and Comparative example 11, 23°C with a solution of 5% aqueous tetramethylammonium hydroxide (hereinafter sometimes referred to as "5% TMAH" (refer to Table 1), (manufactured by Tokyo Ohka Kogyo Co., Ltd., NMD-3)). The wafer was then rinsed with pure water for 15 seconds to obtain a positive pattern.

These patterns were observed with a microscope. The minimum exposure amount capable of removing a 40 μm square pattern exposed portion by dissolution was defined as the sensitivity (mJ/cm$^2$). The results are shown in Table 2. Table 2 also shows whether the pattern had swelled as a result of developing solution seeping into non-exposed portions when observed with the microscope. Cases where the pattern had curved from swelling are indicated with a cross (x) and cases the pattern had not curved are indicated with a circle (O).

When relief patterns were produced by the above-described method using the photosensitive resin composition according to the present invention, a pattern was formed by irradiating a smaller exposure amount than that for the compositions of the comparative examples. When evaluated by observing with a microscope or the like, sharp patterns were observed without any swelling after development. Further, for the patterns having the minimum exposure amount, the smallest size pattern wherein half or more of the square pattern surface area had formed was defined as the resolution (μm), and this is shown in Table 2. Moreover, in Examples 7 to 10 and 13 to 21, an especially good relief pattern resolution was obtained.

A silicon wafer provided with the above-described relief pattern was heated for 1 hour at 250°C under a nitrogen atmosphere using the heating oven VF200B (manufactured by Koyo Thermo Systems Co., Ltd.), to obtain a cured relief pattern having a coating thickness of 3 μm.

In addition, the photosensitive resin composition of Examples 1 to 11 and Comparative Examples 18 to 20 was coated on a 5-inch silicon wafer by a spin coater (manufactured by Tokyo Electron Ltd., Clean Track Mark 7), and then heated for 1 hour at 250°C under a nitrogen atmosphere using the heating oven VF200B (manufactured by Koyo Thermo Systems Co., Ltd.), to produce a heat-resistant film having a coating thickness of 10 μm. The glass transition temperature (Tg (°C)) and thermal expansion coefficient at 50 to 150°C of a film sample on this wafer were measured using the thermomechanical analyzer (manufactured by Shimadzu Corporation, model: TMA-50). The measuring conditions were a sample length of 10 mm, a fixed load of 200 g/mm$^2$, a measurement temperature range of 25 to 450°C, a rate of temperature increase of 10°C/min and a nitrogen atmosphere. The measurement results are shown in Table 3.

Compared with Comparative Example 20, in which a polycondensate was produced that had not completely converted to a polybenzoxazole, Examples 1 to 11 showed a good glass transition temperature of 250°C or more. In terms of thermal expansion coefficient, Examples 2 to 4 and 7 to 10, which had a structure formed by polycondensation of BCD and SO2-HOAB, had a low thermal expansion coefficient of 40 ppm or less.

[Table 1-1]

| | Polycondensate (A) component | Photosensitive diazonaphthoquinone (B) component | Developing solution |
|---|---|---|---|
| Example 1 | P-1 | PAC-8 | Developing solution A |
| Example 2 | P-2 | PAC-8 | Developing solution A |
| Example 3 | P-3 | PAC-8 | Developing solution A |
| Example 4 | P-4 | PAC-8 | Developing solution A |
| Example 5 | P-5 | PAC-8 | 2.38%TMAH |
| Example 6 | P-6 | PAC-8 | 2.38%TMAH |
| Example 7 | P-7 | PAC-8 | 2.38%TMAH |
| Example 8 | P-8 | PAC-8 | 2.38%TMAH |
| Example 9 | P-9 | PAC-8 | 2.38%TMAH |
| Example 10 | P-10 | PAC-8 | 2.38%TMAH |
| Example 11 | P-11 | PAC-8 | 5%TMAH |
| Example 12 | P-12 | PAC-8 | 2.38%TMAH |
| Example 13 | P-7 | PAC-1 | 2.38%TMAH |
| Example 14 | P-7 | PAC-2 | 2.38%TMAH |
| Example 15 | P-7 | PAC-3 | 2.38%TMAH |
| Example 16 | P-7 | PAC-4 | 2.38%TMAH |
| Example 17 | P-7 | PAC-5 | 2.38%TMAH |
| Example 18 | P-7 | PAC-6 | 2.38%TMAH |
| Example 19 | P-7 | PAC-7 | 2.38%TMAH |
| Example 20 | P-7 | PAC-9 | 2.38%TMAH |
| Example 21 | P-7 | PAC-10 | 2.38%TMAH |
| Comparative Example 1 | P-1 | PAC-11 | Developing solution A |
| Comparative Example 2 | P-2 | PAC-11 | Developing solution A |
| Comparative Example 3 | P-3 | PAC-11 | Developing solution A |
| Comparative Example 4 | P-4 | PAC-11 | Developing solution A |
| Comparative Example 5 | P-5 | PAC-11 | 2.38%TMAH |
| Comparative Example 6 | P-6 | PAC-11 | 2.38%TMAH |
| Comparative Example 7 | P-7 | PAC-11 | 2.38%TMAH |
| Comparative Example 8 | P-8 | PAC-11 | 2.38%TMAH |
| Comparative Example 9 | P-9 | PAC-11 | 2.38%TMAH |
| Comparative Example 10 | P-10 | PAC-11 | 2.38%TMAH |
| Comparative Example 11 | P-11 | PAC-11 | 5%TMAH |

[Table 1-2]

| | | | |
|---|---|---|---|
| Comparative Example 12 | P-12 | PAC-11 | 2.38%TMAH |
| Comparative Example 13 | P-13 | PAC-11 | 2.38%TMAH |

(continued)

| | | | |
|---|---|---|---|
| Comparative Example 14 | P-13 | PAC-8 | 2.38%TMAH |
| Comparative Example 15 | P-7 | PAC-12 | 2.38%TMAH |
| Comparative Example 16 | P-7 | PAC-13 | 2.38%TMAH |
| Comparative Example 17 | P-7 | PAC-14 | 2.38%TMAH |
| Comparative Example 18 | P-14 | PAC-15 | 2.38%TMAH |
| Comparative Example 19 | P-15 | PAC-15 | 2.38%TMAH |
| Comparative Example 20 | P-16 | PAC-8 | |

[Table 2-1]

| | Polymer (A) component | PAC (B) component | Developing solution | Sensitivity (mJ/cm$^2$) | Pattern swelling | Resolution (μm) |
|---|---|---|---|---|---|---|
| Example 1 | P-1 | PAC-8 | Developing solution A | 700 | ○ | 30 |
| Example 2 | P-2 | PAC-8 | Developing solution A | 450 | ○ | 25 |
| Example 3 | P-3 | PAC-8 | Developing solution A | 450 | ○ | 15 |
| Example 4 | P-4 | PAC-8 | Developing solution A | 500 | ○ | 20 |
| Example 5 | P-5 | PAC-8 | 2.38%TMAH | 450 | ○ | 9 |
| Example 6 | P-6 | PAC-8 | 2.38%TMAH | 450 | ○ | 15 |
| Example 7 | P-7 | PAC-8 | 2.38%TMAH | 350 | ○ | 2 |
| Example 8 | P-8 | PAC-8 | 2.38%TMAH | 350 | ○ | 3 |
| Example 9 | P- 9 | PAC-8 | 2.38%TMAH | 350 | ○ | 8 |
| Example 10 | P-10 | PAC-8 | 2.38%TMAH | 350 | ○ | 3 |
| Example 11 | P-11 | PAC-8 | 5%TMAH | 500 | ○ | 15 |
| Example 12 | P-12 | PAC-8 | 2.38%TMAH | 450 | ○ | 9 |
| Example 13 | P-7 | PAC-1 | 2.38%TMAH | 300 | ○ | 3 |
| Example 14 | P-7 | PAC-2 | 2.38%TMAH | 250 | ○ | 2 |
| Example 15 | P-7 | PAC-3 | 2.38%TMAH | 200 | ○ | 2 |
| Example 16 | P-7 | PAC-4 | 2.38%TMAH | 250 | ○ | 2 |
| Example 17 | P-7 | PAC-5 | 2.38%TMAH | 250 | ○ | 2 |
| Example 18 | P-7 | PAC-6 | 2.38%TMAH | 350 | ○ | 3 |
| Example 19 | P-7 | PAC-7 | 2.38%TMAH | 450 | ○ | 2 |
| Example 20 | P-7 | PAC-9 | 2.38%TMAH | 350 | ○ | 2 |
| Example 21 | P-7 | PAC-10 | 2.38%TMAH | 500 | ○ | 2 |
| Comparative Example 1 | P-1 | PAC-11 | Developing solution A | >1000 | × | - |
| Comparative Example 2 | P-2 | PAC-11 | Developing solution A | 950 | × | 35 |

(continued)

| | Polymer (A) component | PAC (B) component | Developing solution | Sensitivity ($mJ/cm^2$) | Pattern swelling | Resolution ($\mu m$) |
|---|---|---|---|---|---|---|
| Comparative Example 3 | P-3 | PAC-11 | Developing solution A | 1000 | × | 20 |
| Comparative Example 4 | P-4 | PAC-11 | Developing solution A | 950 | × | 25 |
| Comparative Example 5 | P-5 | PAC-11 | 2.38%TMAH | 1000 | ○ | 15 |
| Comparative Example 6 | P-6 | PAC-11 | 2.38%TMAH | >1000 | × | - |
| Comparative Example 7 | P-7 | PAC-11 | 2.38%TMAH | 950 | × | 9 |
| Comparative Example 8 | P-8 | PAC-11 | 2.38%TMAH | 950 | × | 8 |
| Comparative Example 9 | P-9 | PAC-11 | 2.38%TMAH | 950 | × | 15 |
| Comparative Example 10 | P-10 | PAC-11 | 2.38%TMAH | 950 | × | 8 |
| Comparative Example 11 | P-11 | PAC-11 | 5%TMAH | 950 | × | 25 |

[Table 2-2]

| | Polymer (A) component | PAC (B) component | Developing solution | Sensitivity ($mJ/cm^2$) | Pattern swelling | Resolution ($\mu m$) |
|---|---|---|---|---|---|---|
| Comparative Example 12 | P-12 | PAC-11 | 2.38%TMAH | >1000 | ○ | 15 |
| Comparative Example 13 | P-13 | PAC-11 | 2.38%TMAH | >1000 | × | - |
| Comparative Example 14 | P-13 | PAC-8 | 2.38%TMAH | 1000 | × | 40 |
| Comparative Example 15 | P-7 | PAC-12 | 2.38%TMAH | >1000 | ○ | 10 |
| Comparative Example 16 | P-7 | PAC-13 | 2.38%TMAH | >1000 | × | 15 |
| Comparative Example 17 | P-7 | PAC-14 | 2.38%TMAH | >1000 | × | 15 |
| Comparative Example 18 | P-14 | PAC-15 | 2.38%TMAH | 850 | ○ | 30 |
| Comparative Example 19 | P-15 | PAC-15 | 2.38%TMAH | 950 | ○ | 35 |

[Table 3]

| | Polycondensate (A) component | PAC (B) component | Glass transition temperature (˚C) | Thermal expansion coefficient (ppm/˚C) |
|---|---|---|---|---|
| Example 1 | P-1 | PAC-8 | 269 | 55 |
| Example 2 | P-2 | PAC-8 | 276 | 34 |
| Example 3 | P-3 | PAC-8 | 273 | 33 |
| Example 4 | P-4 | PAC-8 | 250 | 39 |
| Example 5 | P-5 | PAC-8 | 288 | 52 |
| Example 6 | P-6 | PAC-8 | 252 | 47 |
| Example 7 | P-7 | PAC-8 | 288 | 28 |
| Example 8 | P-8 | PAC-8 | 262 | 31 |
| Example 9 | P-9 | PAC-8 | 281 | 26 |
| Example 10 | P-10 | PAC-8 | 251 | 37 |
| Example 11 | P-11 | PAC-8 | 268 | 56 |
| Comparative Example 18 | P-14 | PAC-12 | 264 | 51 |
| Comparative Example 19 | P-15 | PAC-12 | 270 | 47 |
| Comparative Example 20 | P-16 | PAC-8 | 228 | 69 |

INDUSTRIAL APPLICABILITY

The photosensitive resin composition according to the present invention can be suitably used in the field of protective films, interlayer insulation films, liquid crystal orientation films and the like for semiconductors.

## Claims

1. A photosensitive resin composition comprising 1 to 100 parts by mass of a photosensitive diazonaphthoquinone compound (B) based on 100 parts by mass of a polycondensate (A), which has a structure formed from dehydration condensation of one or more tetracarboxylic dianhydrides and one or more aromatic diamines having an amino group and a phenolic hydroxyl group which are located at ortho positions with respect to each other, wherein the polycondensate (A) has a weight average molecular weight of 3,000 to 70,000.

2. The photosensitive resin composition according to claim 1, wherein the polycondensate (A) has a structure formed from dehydration condensation of a tetracarboxylic dianhydride comprising at least one selected from the group consisting of bicyclo(2,2,2)-oct-7-ene-2,3,5,6-tetracarboxylic dianhydride, 2,2-bis(3,4-dicarboxyphenyl)hexafluoropropane dianhydride and bis(3,4-dicarboxyphenyl) ether dianhydride and an aromatic diamine comprising at least one selected from the group consisting of bis(3-amino-4-hydroxyphenyl)sulfone, 2,2-bis(3-amino-4-hydroxyphenyl) hexafluoropropane and 3,3'-dihydroxy-4,4'-diaminobiphenyl.

3. The photosensitive resin composition according to claim 2, wherein the polycondensate (A) has a structure formed from dehydration condensation of a tetracarboxylic dianhydride comprising bicyclo(2,2,2)-oct-7-ene-2,3,5,6-tetracarboxylic dianhydride and an aromatic diamine comprising bis(3-amino-4-hydroxyphenyl)sulfone.

4. The photosensitive resin composition according to claim 3, wherein the polycondensate (A) has a structure formed from dehydration condensation of a tetracarboxylic dianhydride comprising bicyclo(2,2,2)-oct-7-ene-2,3,5,6-tetracarboxylic dianhydride and an aromatic diamine comprising bis(3-amino-4-hydroxyphenyl)sulfone, and wherein the bis(3-amino-4-hydroxyphenyl)sulfone is in a range of 20 to 40 mol% based on all raw material monomers

including all of the tetracarboxylic dianhydride and all of the aromatic diamine, a molar ratio between total number of moles of the tetracarboxylic dianhydride and total number of moles of the aromatic diamine is in a range of 1: 0.75 to 0.87 or 0.75 to 0.87:1, and the polycondensate (A) has a weight average molecular weight in the range of 5,000 to 17,000.

**5.** The photosensitive resin composition according to any one of claims 1 to 4, wherein the photosensitive diazonaphthoquinone compound (B) is at least one compound selected from the group consisting of a 1,2-naphthoquinonediazide-4-sulfonate of a polyhydroxy compound represented by one of the following general formulae (1) to (6) and a 1,2-naphthoquinonediazide-5-sulfonate of the polyhydroxy compound,

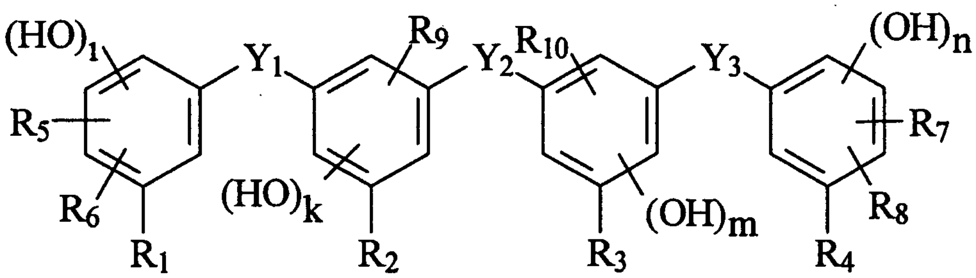

(1)

wherein k, 1, m and n each independently represent 1 or 2; $R_1$ to $R_{10}$ each independently represent at least one monovalent group selected from the group consisting of a hydrogen atom, a halogen atom, an alkyl group, an alkenyl group, an alkoxy group, an allyl group and an acyl group; and $Y_1$ to $Y_3$ each independently represent at least one divalent group selected from the group consisting of a single bond, -O-, -S-, -SO-, $-SO_2$--CO-, $-CO_2$- cyclopentylidene, cyclohexylidene, phenylene and an organic group represented by the following chemical formulae,

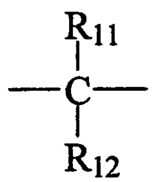

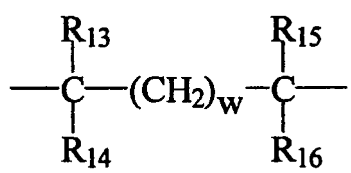

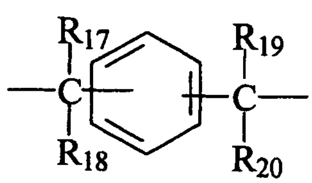

wherein $R_{11}$ and $R_{12}$ each independently represent at least one monovalent group selected from the group consisting of a hydrogen atom, an alkyl group, an alkenyl group, an allyl group and a substituted allyl group; $R_{13}$ to $R_{16}$ represent

a hydrogen atom or an alkyl group which may be the same or different; w represents an integer of 1 to 5; and $R_{17}$ to $R_{20}$ represent a hydrogen atom or an alkyl group which may be the same or different;

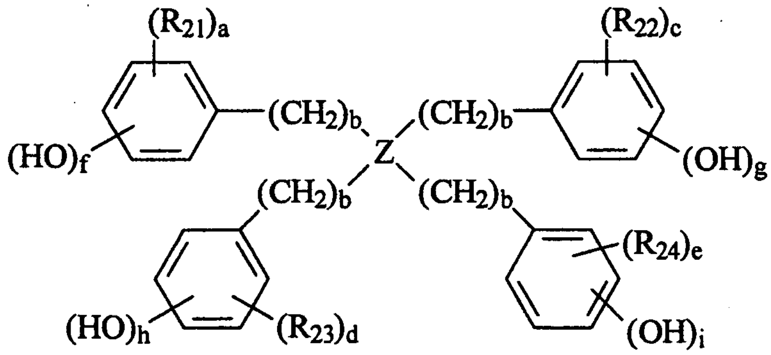

(2)

wherein Z represents at least one tetravalent group selected from the organic groups represented by the following chemical formulae; $R_{21}$, $R_{22}$, $R_{23}$ and $R_{24}$ each independently represent a monovalent organic group; b represents 0 or 1; a, c, d and e each independently represent an integer of 0 to 3; and f, g, h and i each independently represent an integer of 0 to 2;

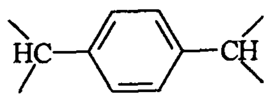

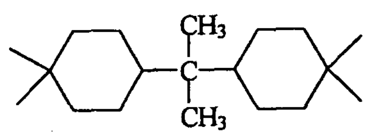

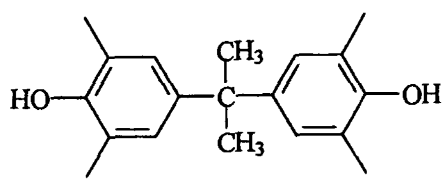

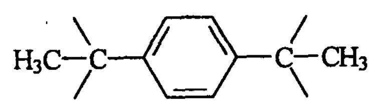

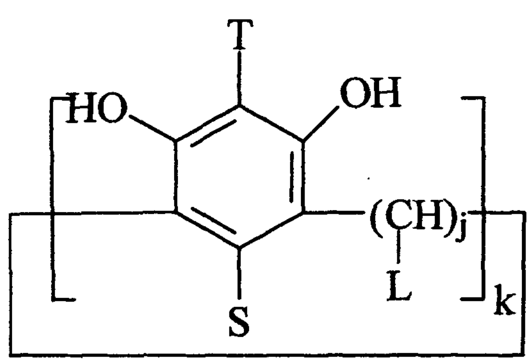

(3)

wherein k represents an integer of 3 to 8; kxj L's each independently represent a monovalent organic group having one or more carbon atoms; j represents an integer of 1 to 5; and k T's and k S's each independently represent a monovalent group selected from the group consisting of a hydrogen atom and a monovalent organic group;

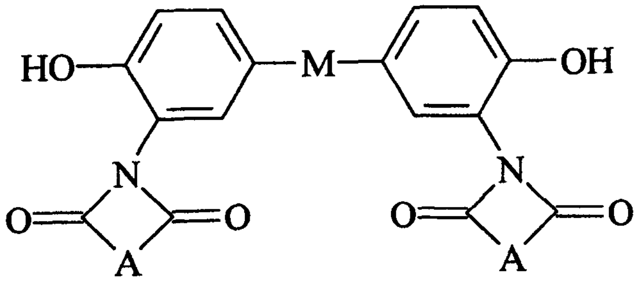

(4)

wherein A represents a divalent organic group containing an aliphatic tertiary or ternary carbon atom; and M represents at least one divalent group selected from the groups represented by the following chemical formulae;

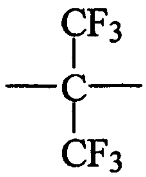

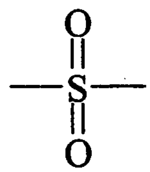

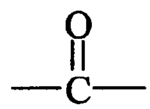

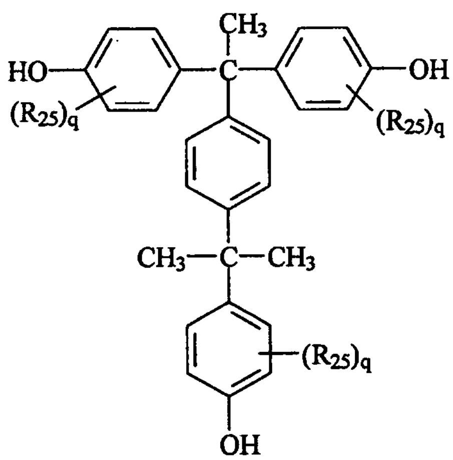

(5)

wherein each $R_{25}$ represents a monovalent group represented by the following chemical formula, and may be the same or different; and each q independently represents an integer of 0 to 2,

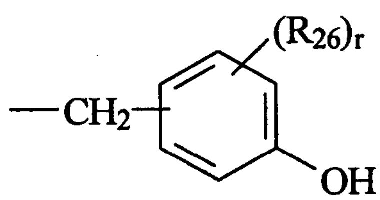

wherein each $R_{26}$ independently represents at least one monovalent organic group selected from the group consisting of an alkyl group and a cycloalkyl group; and each r independently represents an integer of 0 to 2; and

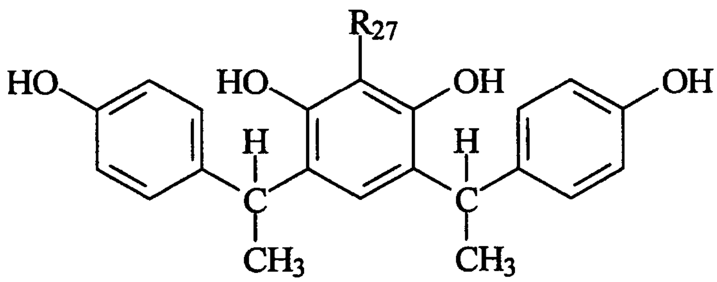

(6)

wherein $R_{27}$ represents at least one monovalent organic group selected from the group consisting of a hydrogen atom, an alkyl group, an alkoxy group and a cycloalkyl group.

**6.** A method for forming a cured relief pattern, comprising: a coating step for forming the photosensitive resin composition according to any one of claims 1 to 4 on a substrate in a form of a layer or a film; an exposure step for exposing the layer or film with actinic rays through a mask or for directly irradiating the layer or film with light rays, an electron beam or an ion beam; a developing step for eluting or removing the exposed portions or irradiated portions with a developing solution; and a heating step for heating an obtained relief pattern.

**7.** A method for forming a cured relief pattern, comprising: a coating step for forming the photosensitive resin composition according to claim 5 on a substrate in a form of a layer or a film; an exposure step for exposing the layer or film with actinic rays through a mask or for directly irradiating the layer or film with light rays, an electron beam or an ion beam; a developing step for eluting or removing the exposed portions or irradiated portions with a developing solution; and a heating step for heating an obtained relief pattern.

**8.** A semiconductor device comprising the cured relief pattern obtained by the formation method according to claim 6.

**9.** A semiconductor device comprising the cured relief pattern obtained by the formation method according to claim 7.

FIG.1

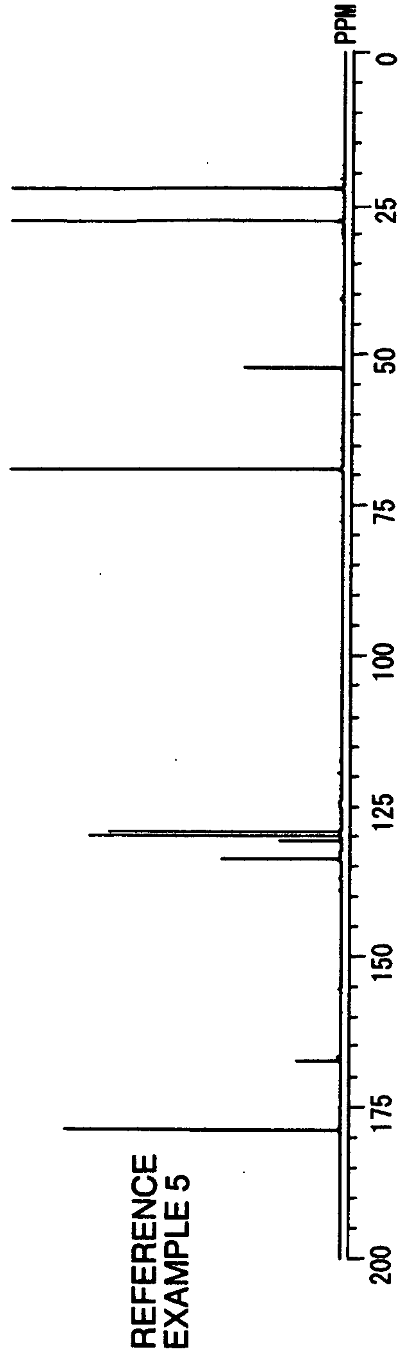


REFERENCE EXAMPLE 5

FIG.2

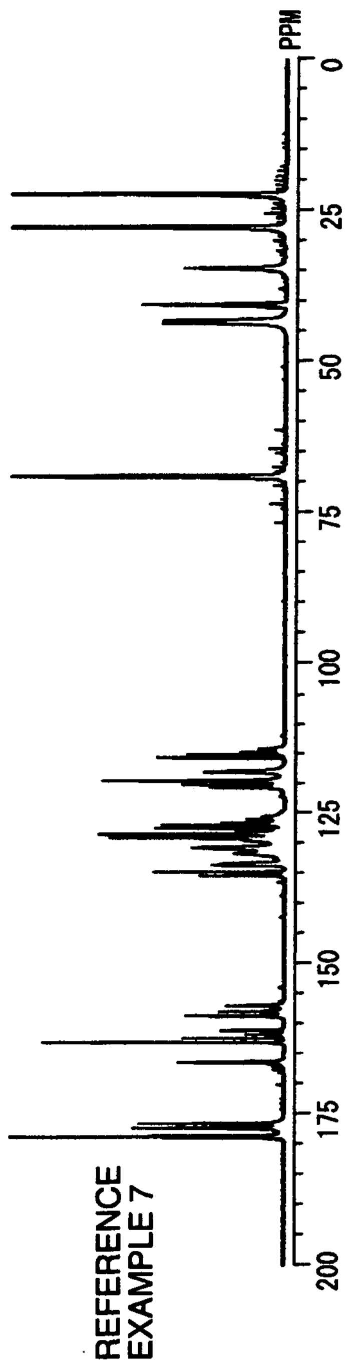

FIG.3

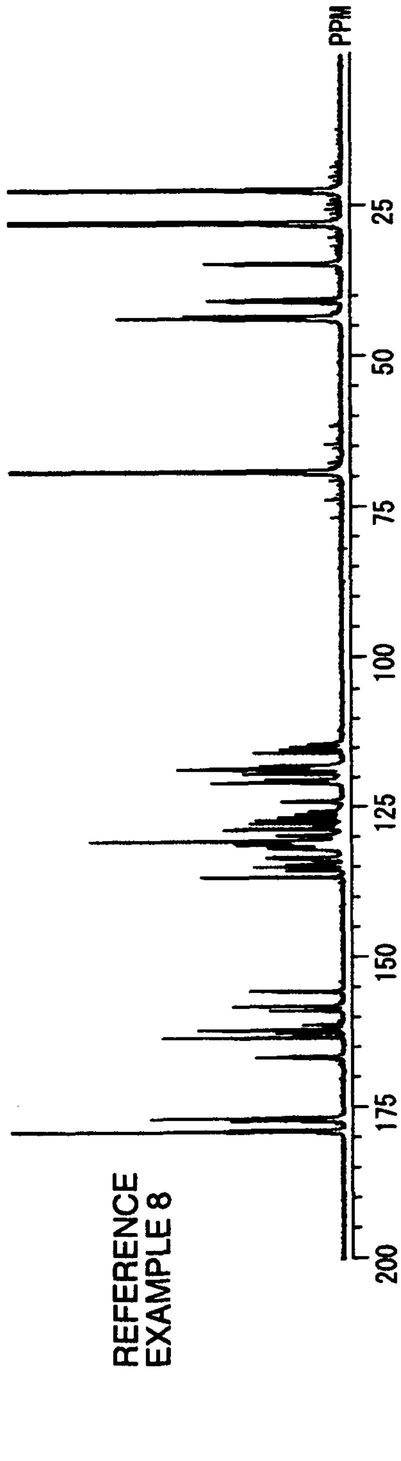

FIG.4

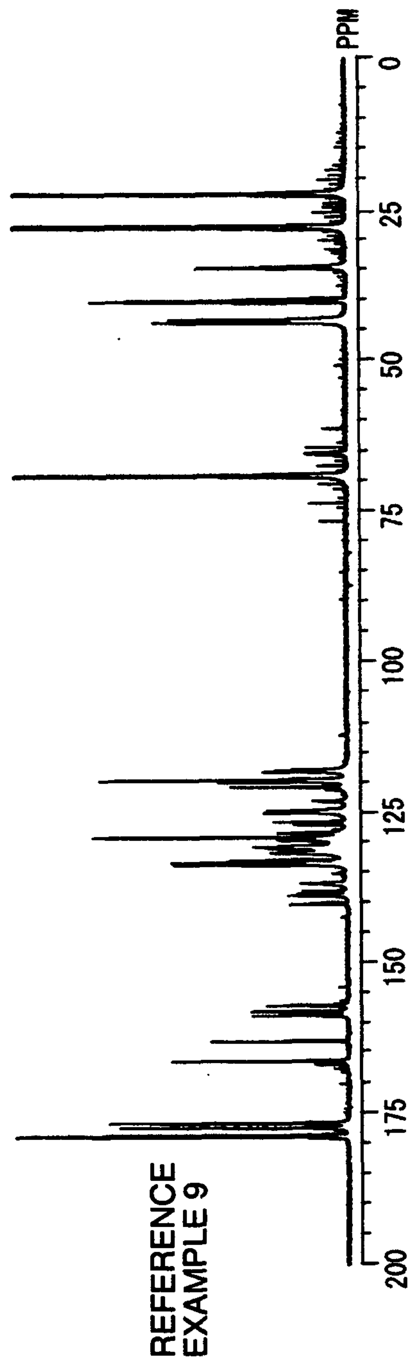

FIG.5

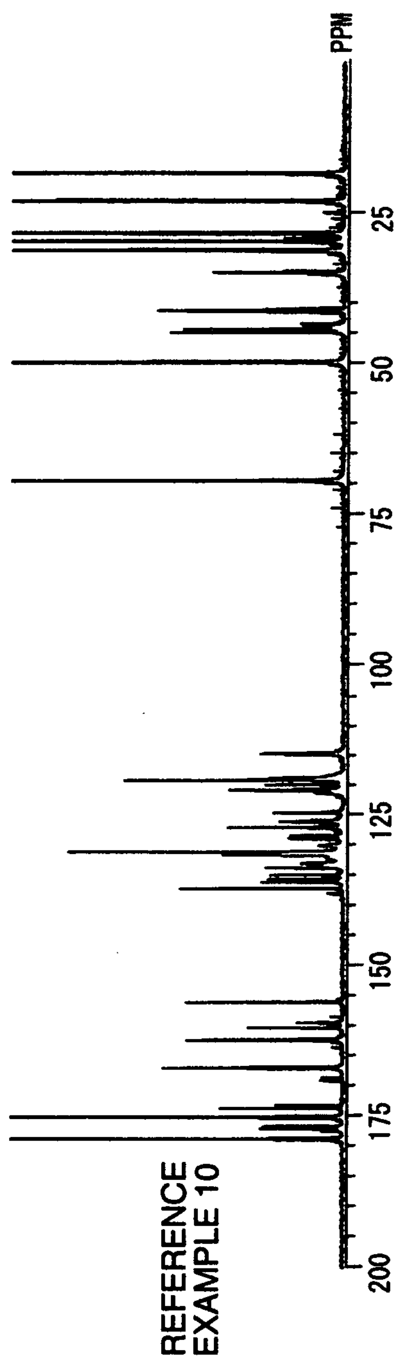

FIG.6

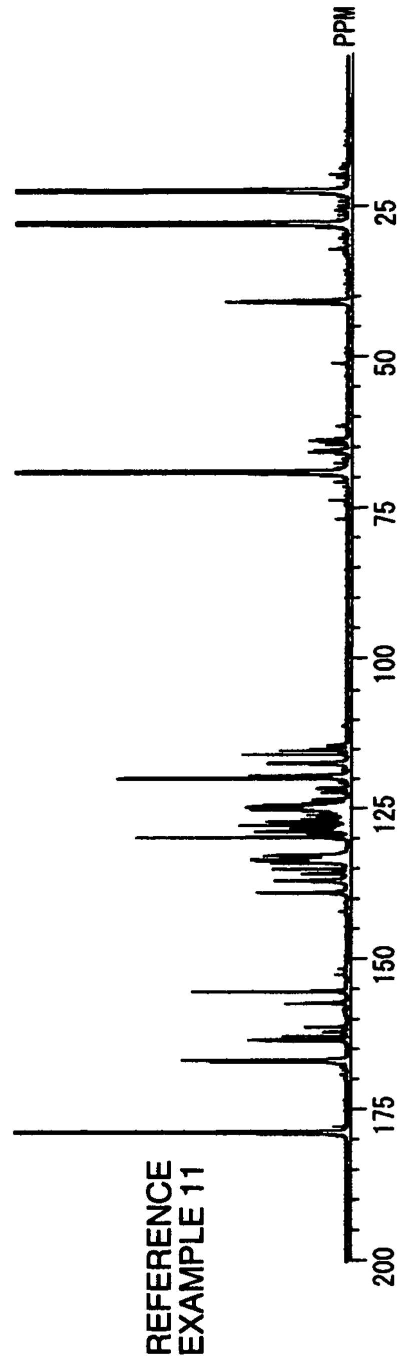

## INTERNATIONAL SEARCH REPORT

International application No.
PCT/JP2006/317325

A. CLASSIFICATION OF SUBJECT MATTER
*G03F7/023*(2006.01)i, *G03F7/022*(2006.01)i, *G03F7/40*(2006.01)i, *H01L21/027*
(2006.01)i

According to International Patent Classification (IPC) or to both national classification and IPC

B. FIELDS SEARCHED

Minimum documentation searched (classification system followed by classification symbols)
G03F7/022-7/023, G03F7/40, H01L21/027

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | WO 01/34679 A1 (PI R&D Co., Ltd.),<br>17 May, 2001 (17.05.01),<br>Claims; examples 8, 13<br>& EP 1262509 A1 & US 6890626 B1 | 1,2,6,8<br>5,7,9<br>3,4 |
| X<br>Y<br>A | WO 03/60010 A1 (PI R&D Co., Ltd.),<br>24 July, 2003 (24.07.03),<br>Page 18, line 7 to page 19, line 24; table 1<br>& AU 2003/201880 A1 & CN 1639262 A<br>& EP 1469037 A1 & US 2005/272907 A1 | 1-3,6,8<br>5,7,9<br>4 |
| X<br>Y<br>A | JP 2003-66608 A (Sumitomo Bakelite Co., Ltd.),<br>05 March, 2003 (05.03.03),<br>Claims; Par. Nos. [0027] to [0030]<br>(Family: none) | 1,2,5-9<br>5,7,9<br>3,4 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 21 September, 2006 (21.09.06) | 03 October, 2006 (03.10.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No. PCT/JP2006/317325

C (Continuation). DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2001-296657 A (Sumitomo Bakelite Co., Ltd.),<br>26 October, 2001 (26.10.01),<br>Claims; Par. Nos. [0023] to [0026]; table 1<br>(Family: none) | 1,5-9<br>5,7,9<br>2-4 |
| X<br>Y<br>A | JP 2001-249454 A (Sumitomo Bakelite Co., Ltd.),<br>14 September, 2001 (14.09.01),<br>Claims; Par. Nos. [0021] to [0024]; tables 1, 2<br>(Family: none) | 1,5-9<br>5,7,9<br>2-4 |
| A | JP 2001-109149 A (Clariant (Japan) Kabushiki Kaisha, Asahi Kasei Corp.),<br>20 April, 2001 (20.04.01),<br>Full text<br>(Family: none) | 5 |
| A | JP 2001-92138 A (Asahi Kasei Corp.),<br>06 April, 2001 (06.04.01),<br>Full text<br>(Family: none) | 5 |
| A | JP 2004-347902 A (Asahi Kasei Electronics Kabushiki Kaisha),<br>09 December, 2004 (09.12.04),<br>Full text<br>(Family: none) | 5 |
| A | JP 2003-131368 A (Asahi Kasei Corp., Clariant (Japan) Kabushiki Kaisha),<br>09 May, 2003 (09.05.03),<br>Full text<br>(Family: none) | 5 |
| A | JP 2001-356475 A (Sumitomo Bakelite Co., Ltd.),<br>26 December, 2001 (26.12.01),<br>Full text<br>(Family: none) | 5 |
| A | JP 11-84653 A (Hitachi Chemical Co., Ltd.),<br>26 March, 1999 (26.03.99),<br>Full text<br>& EP 863436 A1 & JP 10-239842 A<br>& JP 10-333332 A | 1-9 |
| A | JP 4-284455 A (Toshiba Corp.),<br>09 October, 1992 (09.10.92),<br>Full text<br>(Family: none) | 1-9 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6460630 A
- JP 3209478 A
- JP 11084653 A
- JP 249454 A
- WO 2001034679 A
- WO 2003060010 A
- JP 2001109149 A
- JP 2001092138 A
- JP 2004347902 A
- JP 2003131368 A
- JP 2004109849 A
- JP 2001356475 A